# FASCICULE DE BREVET EUROPEEN

(11) **EP 3 206 230 B1**
(45) Date de publication et mention de la délivrance du brevet: **13.03.2019**
(21) Numéro de dépôt: 17155594.9
(22) Date de dépôt: 10.02.2017
(51) Int. Cl.: H01L 23/522

(54) **DISPOSITIF A STRUCTURE D'INTERCONNEXIONS POUR FORMER UN CHEMIN DE CONDUCTION OU UN PLAN CONDUCTEUR A FORTE CAPACITE DE DECOUPLAGE**
BAUTEIL MIT VERBINDUNGSSTRUKTUR ZUM BILDEN EINES LEITENDEN PFADS ODER EINER LEITFÄHIGEN FLÄCHE MIT HOHER ENTKOPPLUNGSFÄHIGKEIT
DEVICE WITH INTERCONNECTION STRUCTURE FOR FORMING A CONDUCTION PATH OR A CONDUCTIVE PLANE WITH HIGH DECOUPLING CAPABILITY

(30) Priorité: 11.02.2016 FR 1651108
(43) Date de publication de la demande: 16.08.2017
(73) Titulaire: COMMISSARIAT À L'ÉNERGIE ATOMIQUE ET AUX ÉNERGIES ALTERNATIVES, 75015 Paris (FR)
(72) Inventeur: GONZALEZ JIMENEZ, José-Luis, 38340 VOREPPE (FR)
(74) Mandataire: Brevalex

(56) Documents cités:
- EP-A1- 0 920 036
- WO-A1-2008/054324

## Description

### DOMAINE TECHNIQUE ET ART ANTÉRIEUR

L'invention porte sur un dispositif électronique comportant une structure d'interconnexions permettant la réalisation d'au moins un chemin de conduction et/ou d'au moins un plan conducteur, adaptée à la distribution de plusieurs signaux électriques et à forte capacité de découplage. Une telle structure d'interconnexions fait avantageusement partie du back-end, ou «back-end of line » (BEOL), d'un circuit intégré.

La partie back-end d'un dispositif électronique tel qu'un circuit intégré est formée par un empilement de plusieurs niveaux d'interconnexions métalliques (généralement appelés, selon leur position occupée par rapport au circuit intégré, METAL 1, METAL 2, etc.) comprenant chacun des lignes électriquement conductrices permettant la propagation des signaux dans les différents éléments du circuit intégré. Un matériau diélectrique inter-couches (ILD pour « InterLayer Dielectric ») est disposé entre deux niveaux d'interconnexions métalliques voisins, ou successifs. Les lignes conductrices des différents niveaux d'interconnexions sont reliées électriquement entre elles par des vias conducteurs qui traversent un ou plusieurs des matériaux diélectriques inter-couches selon les niveaux auxquels appartiennent les lignes conductrices devant être reliées entre elles.

Une partie du back-end forme une structure d'interconnexions électriques dédiée à la distribution du ou des signaux électriques d'alimentation, de polarisation, et d'un potentiel de référence ou potentiel de masse.

Pour assurer cette distribution, il est connu de réaliser cette structure d'interconnexions électriques sous la forme d'une grille, comme décrit dans le document "High Performance Power Distribution Networks with On-Chip Decoupling Capacitors for Nanoscale Integrated Circutis" de Mikhail Popovich, Department of Electrical and Computer Engineering, Univeristy of Rochester, New York, 2007, chapitre 4. Dans une telle structure, les lignes conductrices appartenant à un même niveau d'interconnexions sont orientées parallèlement les unes des autres. De plus, les lignes conductrices de deux niveaux d'interconnexions consécutifs sont orientées perpendiculairement les unes par rapport aux autres.

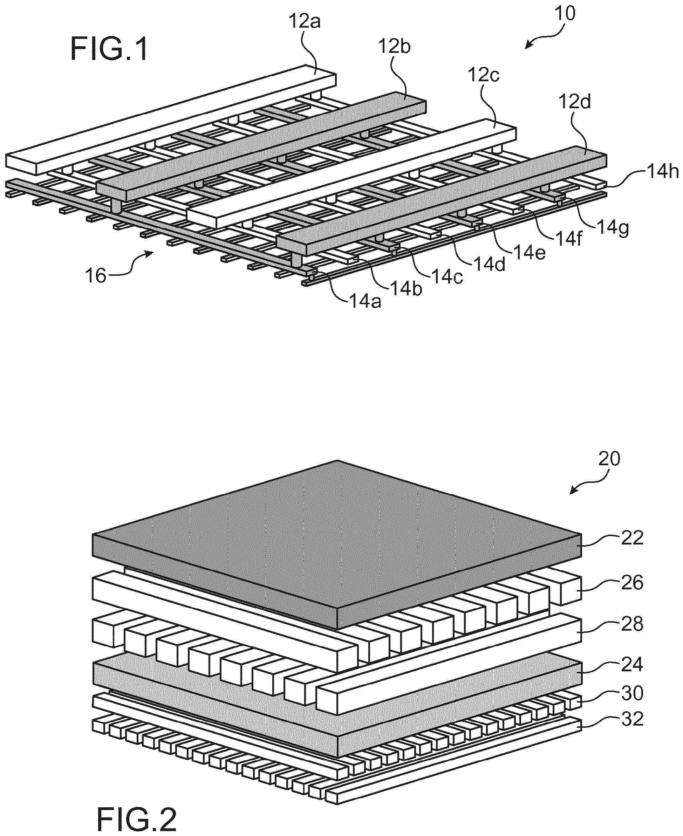

Une telle structure d'interconnexions est représentée schématiquement sur la figure 1. Sur cette figure, la structure d'interconnexions 10 comporte trois niveaux d'interconnexions métalliques. Les références 12a à 12d désignent les lignes conductrices du troisième niveau d'interconnexions, les références 14a à 14h désignent les lignes conductrices du deuxième niveau d'interconnexions, et la référence 16 désigne de manière globale les lignes conductrices du premier niveau d'interconnexions (celui le plus proche du circuit intégré sur lequel la structure d'interconnexions est destinée à être réalisée). On voit sur cette figure que dans chacun des niveaux d'interconnexions, les lignes conductrices sont parallèles les unes des autres, que les lignes conductrices 12a-12d sont parallèles aux lignes conductrices 16, et que les lignes conductrices 14a-14h sont perpendiculaires aux lignes conductrices 12a-12d et 16.

Dans une telle structure d'interconnexions, certaines lignes conductrices de chaque niveau d'interconnexions servent à la distribution du signal d'alimentation électrique et les autres lignes conductrices de chaque niveau d'interconnexions servent à la distribution du potentiel de référence. Sur la figure 1, dans le troisième niveau d'interconnexions, les lignes conductrices 12a et 12c servent à l'acheminement du potentiel de référence et les lignes conductrices 12b et 12d servent à l'acheminement du signal d'alimentation. Dans le deuxième niveau d'interconnexions, les lignes conductrices 14b, 14d, 14f et 14h servent à l'acheminement du potentiel de référence et les lignes conductrices 14a, 14c, 14e et 14g servent à l'acheminement du signal d'alimentation. De même, certaines des lignes conductrices 16 servent à l'acheminement du potentiel de référence et les autres lignes conductrices 16 servent à l'acheminement du signal d'alimentation. Dans chacun des niveaux d'interconnexions, les lignes conductrices distribuant le potentiel de référence et celles distribuant le signal d'alimentation sont disposées côte à côte de manière alternée. Enfin, les lignes conductrices de deux niveaux voisins distribuant un même signal (le signal d'alimentation ou le potentiel de référence) sont reliées électriquement entre elles par des vias conducteurs qui permettent cette distribution des deux signaux dans tous les niveaux d'interconnexions. Bien que non représentés, des matériaux diélectriques inter-couches séparent les différents niveaux entre eux.

Un autre exemple de structure d'interconnexions 20 est représenté sur la figure 2. Dans cette structure, la tension d'alimentation électrique est distribuée par deux niveaux d'interconnexions, référencés 22 et 24, et réalisés sous la forme de plans conducteurs continus et non de lignes conductrices espacées les unes des autres. Le potentiel de référence est distribué par quatre autres niveaux d'interconnexions, référencés 26, 28, 30 et 32, formés chacun de lignes conductrices qui sont orientées parallèlement les unes des autres au sein d'un même niveau d'interconnexions. De plus, les lignes conductrices du niveau d'interconnexions 28 sont orientées perpendiculairement par rapport à celles du niveau d'interconnexions 26. En outre, les lignes conductrices du niveau d'interconnexions 30 sont orientées perpendiculairement à celles du niveau d'interconnexions 32.

Dans les structures d'interconnexions 10 et 20 précédemment décrites, les lignes conductrices de deux niveaux voisins ou successifs sont orientées perpendiculairement les unes des autres pour former des capacités parasites entre les niveaux distribuant des signaux différents, et donc de former des capacités de découplage entre ces signaux.

La réalisation de plans conducteurs continus, comme les niveaux d'interconnexions 22 et 24 de la structure d'interconnexions 20 de la figure 2, n'est toutefois pas autorisée par les règles de dessins imposées dans la plupart des procédés de fabrication récents de circuits intégrés.

Le document A.M. Mangan et al., « De-Embedding Transmission Line Measurements for accurate Modelling of IC Designs », IEEE Trans. Electron. Devices, vol. 53, n°2, pp. 235-241, n°2, février 2006, décrit que lorsqu'il n'est pas permis d'avoir des plans continus dans les niveaux d'interconnexions, ces niveaux d'interconnexions peuvent être réalisés sous la forme de maillages comportant des parties vides réparties régulièrement afin d'atteindre la densité de métal définie par les règles de dessins imposées au design de la structure. Ce document propose notamment de remplacer un plan conducteur par deux niveaux d'interconnexions consécutifs reliés entre eux par des vias conducteurs et réalisés tels que les maillages de ces deux niveaux d'interconnexions électriques soient décalés l'un par rapport à l'autre afin d'obtenir, vue de dessus, une structure pouvant s'apparenter à un plan conducteur continu.

La structure d'interconnexions 10 précédemment décrite est généralement utilisée pour des circuits intégrés numériques. Toutefois, cette structure d'interconnexions 10 n'est pas adaptée pour des circuits intégrés analogiques RF qui nécessitent d'avoir une plus forte densité de métal au sein des niveaux d'interconnexions. De plus, cette structure d'interconnexions 10 ne permet pas de distribuer plus de deux signaux.

La structure d'interconnexions 20 permet de distribuer plus de deux signaux différents mais n'est pas optimisée en termes de découplage capacitif entre les différents éléments propageant les différents signaux. Ce problème de découplage capacitif n'est pas non plus résolu lorsque deux niveaux successifs sont réalisés sous la forme de maillages décalés et reliés entre eux par des vias conducteurs.

Le document EP 0 920 036 A1 (ST MICROELECTRONICS SA [FR]; FRANCE TELECOM [FR]) 2 juin 1999 (1999-06-02) est une autre pièce de l'art antérieur qui peut être considérée comme pertinent.

### EXPOSÉ DE L'INVENTION

Un but de la présente invention est de proposer un dispositif électronique comportant une structure d'interconnexions qui soit adaptée à la distribution de deux signaux ou plus de deux signaux dans au moins un chemin de conduction entre au moins deux points du dispositif et/ou dans au moins un plan électriquement conducteur, dont l'architecture permet d'obtenir une très forte densité de métal au sein de tous les niveaux d'interconnexions, tout en maximisant le découplage capacitif entre les éléments distribuant les différents signaux.

Pour cela, la présente invention propose un dispositif électronique comportant une structure d'interconnexions électriques formant au moins un chemin de conduction électrique entre au moins deux points du dispositif électronique et/ou au moins un plan électriquement conducteur, et comportant un empilement alterné de réseaux de lignes conductrices et de couches diélectriques dans lequel :
- toutes les lignes conductrices d'un même réseau s'étendent dans un même plan et forment un equipotentiel ;
- un premier motif des lignes conductrices d'un premier réseau est tel qu'au moins une première des lignes conductrices du premier réseau s'étend selon au moins une première direction et plusieurs deuxièmes des lignes conductrices du premier réseau croisent la première des lignes conductrices du premier réseau en plusieurs intersections ;
- un troisième motif des lignes conductrices d'un troisième réseau est similaire au premier motif, les premier et troisième motifs étant superposés l'un au-dessus de l'autre et tels que les intersections du premier motif sont alignées avec les intersections du troisième motif selon un axe sensiblement perpendiculaire aux plans dans lesquels s'étendent les lignes conductrices des premier et troisième réseaux ;
- un deuxième motif des lignes conductrices d'un deuxième réseau disposé entre les premier et troisième réseaux est tel qu'au moins une première des lignes conductrices du deuxième réseau s'étend selon la première direction et plusieurs deuxièmes des lignes conductrices du deuxième réseau croisent la première des lignes conductrices du deuxième réseau en plusieurs intersections décalées par rapport aux intersections des premier et troisième motifs ;
- au moins un premier via conducteur s'étend à travers au moins une partie d'au moins une des couches diélectriques interposées entre les premier et troisième réseaux de lignes conductrices, est en contact avec au moins une des lignes conductrices du premier réseau et/ou du troisième réseau et est tel qu'une section du premier via conducteur projetée dans un plan par lequel passent les lignes conductrices du deuxième réseau n'est pas en contact avec les lignes conductrices du deuxième réseau (ou est espacée des lignes conductrices du deuxième réseau, ou est isolée électriquement des lignes conductrices du deuxième réseau).

Cette structure d'interconnexions propose donc de distribuer plusieurs signaux dans au moins trois réseaux de lignes conductrices superposés et qui permettent, grâce au fait que les intersections des lignes conductrices du deuxième réseau sont décalées par rapport aux intersections des lignes conductrices des premier et troisième réseaux (qui elles sont alignées les unes au-dessus des autres), de relier les lignes conductrices des premier et troisième réseaux entre elles grâce au(x) premier(s) via(s) conducteur(s) qui traverse(nt) le deuxième réseau sans venir en contact avec les lignes conductrices du deuxième réseau.

Cette structure permet de distribuer plus de deux signaux différents car chaque réseau de lignes conductrices peut être destiné à distribuer un signal différent, contrairement aux structures de l'art antérieur dans lesquelles les deux signaux distribués sont présents dans les lignes conductrices de chaque niveau.

En outre, du fait qu'un même signal peut être distribué par plusieurs réseaux de la structure, par exemple les premier et troisième réseaux lorsque les lignes conductrices de ces réseaux sont reliées électriquement entre elles par un ou plusieurs premiers vias conducteurs, cela permet de réduire les impédances série de ces réseaux du fait de la multiplication des chemins de propagation du courant de ce signal. L'utilisation de réseaux alternés (premier et troisième réseaux par exemple) pour distribuer un même signal permet de d'augmenter la capacité parasite vis-à-vis du ou des autre signaux distribués par la structure et permet donc d'augmenter la capacité de découplage de mode commun entre les signaux distribués par la structure d'interconnexions.

L'augmentation de la capacité de couplage est également due aux motifs des réseaux de lignes conductrices de la structure. En effet, en considérant par exemple les premier et troisième réseaux, du fait que les intersections du deuxième motif (du deuxième réseau) sont décalées par rapport aux intersections du premier motif (des premier et troisième réseaux), la capacité de découplage est accrue en raison des surfaces importantes de lignes conductrices selon le premier motif qui sont disposées en regard l'une de l'autre.

La structure d'interconnexions permet avantageusement de distribuer dans le plan conducteur ou dans le chemin de conduction des signaux continus et/ou basse fréquence comme par exemple les tensions d'alimentation et de référence (masse).

L'invention s'applique avantageusement pour des circuits intégrés RF et/ou ayant des vitesses de fonctionnement élevées dans lesquels un plan de masse est utilisé au niveau de toutes les parties du circuit non occupées par des composants actifs ou passifs.

L'invention permet également de distribuer les tensions d'alimentation et de polarisation avec une grande stabilité et permet un fort découplage entre la masse et les signaux d'alimentation continus.

Enfin, l'invention permet d'avoir une densité de métal suffisante dans chaque niveau de la structure d'interconnexions pour répondre aux densités de métal minimales imposées par les règles de dessins auxquelles le circuit réalisé doit répondre.

Le ou les premiers vias conducteurs, qui sont reliés électriquement au premier et/ou troisième réseaux de lignes conductrices, accroissent également cette capacité de découplage car il(s) augmente(nt) la surface de matériau conducteur à proximité du deuxième réseau.

Les intersections des lignes conductrices du deuxième réseau sont décalées par rapport aux intersections des lignes conductrices des premier et troisième réseaux, c'est-à-dire que lorsque les intersections des premier, deuxième et troisième réseaux sont projetées dans un même plan parallèle à ceux dans lesquels s'étendent les lignes conductrices de ces réseaux, les projections des intersections du deuxième réseau ne se superposent pas aux projections des intersections des premier et troisième réseaux.

Le dispositif peut comporter plusieurs premiers vias conducteurs s'étendant à travers les couches diélectriques interposées entre les premier et troisième réseaux de lignes conductrices et reliant chacun électriquement une des intersections du premier réseau de lignes conductrices à une des intersections du troisième réseau de lignes conductrices par l'intermédiaire d'une portion conductrice du deuxième réseau qui est isolée électriquement des lignes conductrices du deuxième réseau. Outre le fait que ces portions conductrices du deuxième réseau facilitent la réalisation des premiers vias conducteurs, elles permettent également d'augmenter la capacité de découplage entre le deuxième réseau et les premier et troisième réseaux.

Le dispositif peut comporter en outre au moins un deuxième via conducteur s'étendant à travers au moins une partie d'au moins une des couches diélectriques interposée entre les premier et troisième réseaux de lignes conductrices, en contact avec au moins une des lignes conductrices du deuxième réseau et tel qu'une section du deuxième via conducteur projetée dans un plan par lequel passent les lignes conductrices du premier réseau n'est pas en contact avec les lignes conductrices du premier réseau. Ce ou ces deuxièmes vias conducteurs permettent d'augmenter encore la capacité de découplage entre le deuxième réseau et les premier et troisième réseaux. De plus, lorsque la structure d'interconnexions comporte au moins quatre réseaux de lignes conductrices, ce ou ces deuxièmes vias conducteurs permettent de relier les lignes conductrices du deuxième réseau à des lignes conductrices d'un quatrième réseau (le troisième réseau étant disposé entre les deuxième et quatrième réseaux) afin que les lignes conductrices des deuxième et quatrième réseaux puissent distribuer un même signal différent de celui distribué par les lignes conductrices des premier et troisième réseaux.

Le dispositif peut comporter plusieurs deuxièmes vias conducteurs s'étendant à travers les couches diélectriques interposées entre les premier et troisième réseaux de lignes conductrices, chacun étant en contact avec une des intersections du deuxième réseau de lignes conductrices et avec une portion conductrice du premier réseau qui est isolée électriquement des lignes conductrices du premier réseau et/ou une portion conductrice du troisième réseau qui est isolée électriquement des lignes conductrices du troisième réseau. Les portions conductrices du premier et/ou troisième réseaux auxquelles sont reliés les deuxièmes vias conducteurs permettent d'augmenter la capacité de découplage entre le deuxième réseau et les premier et troisième réseaux.

Les premier et troisième motifs des lignes conductrices des premier et troisième réseaux peuvent correspondre respectivement à un premier et un troisième quadrillages alignés et superposés l'un au-dessus de l'autre, et le deuxième motif des lignes conductrices du deuxième réseau peut correspondre à un deuxième quadrillage décalé par rapport aux premier et troisième quadrillages. Le deuxième quadrillage est décalé par rapport aux premier et troisième quadrillages, c'est-à-dire que les intersections des lignes formant les premier et troisième quadrillages, lorsqu'elles sont projetées dans le plan dans lequel se trouve le deuxième quadrillage, ne se superposent pas à celles formées par le croisement des lignes du deuxième quadrillage.

Lorsque la structure d'interconnexions comporte les premiers et deuxièmes vias conducteurs et que les motifs des réseaux forment des quadrillages décalés deux à deux, les premiers vias conducteurs peuvent traverser des ouvertures formées dans le deuxième quadrillage et les deuxièmes vias conducteurs traversent des ouvertures formées dans au moins l'un des premier et troisième quadrillages.

Les lignes conductrices d'un même réseau peuvent se croiser de manière sensiblement perpendiculaire.

Au moins une des premières des lignes conductrices d'un des réseaux est interrompue. La structure d'interconnexions peut donc être réalisée telle que la distribution d'au moins un des signaux soit interrompue en au moins un point du chemin de conduction électrique et/ou du plan électriquement conducteur.

Le dispositif peut comporter en outre un ou plusieurs autres réseaux de lignes conductrices superposés aux premier, deuxième et troisième réseaux de lignes conductrices et dont les lignes conductrices forment un motif similaire et aligné au premier ou au deuxième motif tel que les motifs formés par les lignes conductrices de l'ensemble des réseaux correspondent une superposition alternée des premier et deuxième motifs.

Le dispositif peut comporter en outre au moins un circuit intégré analogique et la structure d'interconnexions peut former des plans de masse et d'alimentation électrique dudit au moins un circuit intégré analogique.

L'invention porte également sur un procédé de réalisation d'un dispositif électronique comportant une structure d'interconnexions électriques formant au moins un chemin de conduction électrique entre au moins deux points du dispositif électronique et/ou au moins un plan électriquement conducteur, dans lequel le procédé comporte une étape de conception assistée par ordinateur du chemin de conduction électrique et/ou du plan électriquement conducteur à partir de plusieurs cellules de connexion similaires modélisant chacune une partie d'un empilement alterné de réseaux de lignes conductrices et de couches diélectriques dans lequel :
- toutes les lignes conductrices d'un même réseau s'étendent dans un même plan et forment un equipotentiel ;
- un premier motif des lignes conductrices d'un premier réseau est tel qu'au moins une première des lignes conductrices du premier réseau s'étend selon au moins une première direction et plusieurs deuxièmes des lignes conductrices du premier réseau croisent la première des lignes conductrices du premier réseau en plusieurs intersections ;
- un troisième motif des lignes conductrices d'un troisième réseau est similaire au premier motif, les premier et troisième motifs étant superposés l'un au-dessus de l'autre et tels que les intersections du premier motif sont alignées avec les intersections du troisième motif selon un axe sensiblement perpendiculaire aux plans dans lesquels s'étendent les lignes conductrices des premier et troisième réseaux ;
- un deuxième motif des lignes conductrices d'un deuxième réseau disposé entre les premier et troisième réseaux de lignes conductrices est tel qu'au moins une première des lignes conductrices du deuxième réseau s'étend selon la première direction et plusieurs deuxièmes des lignes conductrices du deuxième réseau croisent la première des lignes conductrices du deuxième réseau en plusieurs intersections décalées par rapport aux intersections des premier et troisième motifs ;
- au moins un premier via conducteur s'étend à travers au moins une partie d'au moins une des couches diélectriques interposée entre les premier et troisième réseaux de lignes conductrices, est en contact avec au moins une des lignes conductrices du premier réseau et/ou du troisième réseau et tel qu'une section du premier via conducteur projetée dans un plan par lequel passent les lignes conductrices du deuxième réseau n'est pas en contact avec les lignes conductrices du deuxième réseau ;
et dans lequel, lors de l'étape de conception assistée par ordinateur du chemin de conduction électrique et/ou du plan électriquement conducteur, une pluralité de cellules de connexion sont juxtaposées et mises en contact latéralement les unes aux autres pour former le chemin de conduction électrique et/ou le plan électriquement conducteur.

La conception de la structure d'interconnexions est ici mise en oeuvre à partir d'une cellule de connexion unitaire qui est dupliquée plusieurs fois telle que les cellules de connexion juxtaposées les unes aux autres forment le ou les chemins de conduction électrique et/ou le ou les plans électriquement conducteurs. Chaque cellule de connexion comporte une partie de chacun des réseaux de lignes conductrices, correspondant aux différents niveaux d'interconnexions de la structure, et une partie de chacune des couches diélectriques (ILD) de la structure d'interconnexions. La configuration de cette structure d'interconnexions permet d'obtenir une excellente densité des lignes de connexions ainsi qu'une très bonne capacité de découplage entre les différents niveaux d'interconnexions.

Chacune des cellules de connexion peut être telle qu'au moins une des lignes conductrices de chacun des réseaux s'étend entre un premier coin ou un premier bord de la cellule de connexion et un deuxième coin ou un deuxième bord de la cellule de connexion.

Chacune des cellules de connexion peut comporter au moins une partie de la première des lignes conductrices et au moins une des deuxièmes des lignes conductrices de chacun des réseaux.

Il est également décrit un dispositif électronique comportant une structure d'interconnexions électriques, comprenant un empilement alterné de couches diélectriques et de niveaux électriquement conducteurs comprenant chacun des lignes conductrices formant au moins un chemin de conduction électrique entre au moins deux points du dispositif électronique et/ou au moins un plan électriquement conducteur, dans lequel :
- ledit empilement est structuré en formant, dans un plan parallèle aux couches et aux niveaux de l'empilement, plusieurs cellules de connexion identiques, juxtaposées et en contact latéralement les unes aux autres telles que des portions de lignes conductrices des niveaux électriquement conducteurs de cellules de connexion voisines sont en contact et forment des liaisons électriques s'étendant parallèlement au dit plan, et
- dans chacune des cellules de connexion, lesdites portions de lignes conductrices de chacun des niveaux électriquement conducteurs sont telles qu'en juxtaposant, dans ledit plan, quatre cellules de connexion en formant un carré dont chaque côté est formé par deux des quatre cellules de connexion, les portions de lignes conductrices de deux des niveaux électriquement conducteurs, appelés premier et troisième niveaux électriquement conducteurs, entre lesquels est disposé un autre des niveaux électriquement conducteurs, appelé deuxième niveau électriquement conducteur, forment deux premiers quadrillages alignés l'un par rapport à l'autre selon un axe sensiblement perpendiculaire au dit plan, et les portions de lignes conductrices du deuxième niveau électriquement conducteur forment un deuxième quadrillage, et
- les motifs des premiers quadrillages sont décalés par rapport à celui du deuxième quadrillage tels que des premiers vias électriquement conducteurs relient électriquement les portions de lignes conductrices des premier et troisième niveaux électriquement conducteurs à travers des ouvertures formées dans le deuxième quadrillage et que des deuxièmes vias électriquement conducteurs sont reliés électriquement aux portions de lignes conductrices du deuxième niveau électriquement conducteur à travers des ouvertures formées dans au moins l'un des premiers quadrillages.

Chacune des cellules de connexion peut avoir une forme, dans ledit plan, sensiblement rectangulaire.

Chacune des cellules de connexion peut être telle que, selon une première configuration :
- les portions de lignes conductrices du deuxième niveau électriquement conducteur forment deux segments se croisant sensiblement perpendiculairement l'un par rapport l'autre et dont les extrémités sont disposées au niveau des bords de la cellule de connexion ;
- les portions de lignes conductrices de chacun des premier et troisième niveaux électriquement conducteurs sont disposées au niveau des bords de la cellule de connexion et forment un rectangle délimitant un espace vide en regard duquel se trouve l'intersection des segments formés par les portions de lignes conductrices du deuxième niveau électriquement conducteur ;
ou telle que, selon une deuxième configuration :
- les portions de lignes conductrices de chacun des premier et troisième niveaux électriquement conducteurs forment deux segments se croisant sensiblement perpendiculairement l'un par rapport l'autre et dont les extrémités sont disposées au niveau des bords de la cellule de connexion ;
- les portions de lignes conductrices du deuxième niveau électriquement conducteur sont disposées au niveau des bords de la cellule de connexion et forment un rectangle délimitant un espace vide en regard duquel se trouve l'intersection des segments formés par les portions de lignes conductrices de chacun des premier et troisième niveaux électriquement conducteurs.

Dans ce cas, chacune des cellules de connexion peut être telle que :
- selon la première configuration, plusieurs des premiers vias électriquement conducteurs sont disposés au niveau des coins des rectangles formés par les portions de lignes conductrices des premier et troisième niveaux électriquement conducteurs et l'un des deuxièmes vias électriquement conducteurs est disposé au niveau de l'intersection des segments formés par les portions de lignes conductrices du deuxième niveau électriquement conducteur, ou
- selon la deuxième configuration, l'un des premiers vias électriquement conducteurs est disposé au niveau des intersections des segments formés par les portions de lignes conductrices des premier et troisième niveaux électriquement conducteurs et plusieurs des deuxièmes vias électriquement conducteurs sont disposés au niveau des coins du rectangle formé par les portions de lignes conductrices du deuxième niveau électriquement conducteur.

Selon une autre variante, chacune des cellules de connexion peut être telle que, selon une première configuration :
- les portions de lignes conductrices du deuxième niveau électriquement conducteur forment deux segments se croisant sensiblement au niveau du centre du rectangle formé par la cellule de connexion dans ledit plan, et dont les extrémités sont disposées au niveau des bords de la cellule de connexion ;
- les portions de lignes conductrices de chacun des premier et troisième niveaux électriquement conducteurs forment, dans ledit plan, un losange dont les sommets sont disposés au niveau des bords de la cellule de connexion et délimitant un espace vide en regard duquel se trouve l'intersection des segments formés par les portions de lignes conductrices du deuxième niveau électriquement conducteur ;
ou telle que, selon une deuxième configuration :
- les portions de lignes conductrices de chacun des premier et troisième niveaux électriquement conducteurs forment deux segments se croisant sensiblement au niveau du centre du rectangle formé par la cellule de connexion dans ledit plan, et dont les extrémités sont disposées au niveau des bords de la cellule de connexion ;
- les portions de lignes conductrices du deuxième niveau électriquement conducteur forment, dans ledit plan, un losange dont les sommets sont disposés au niveau des bords de la cellule de connexion et délimitant un espace vide en regard duquel se trouve l'intersection des segments formés par les portions de lignes conductrices de chacun des premier et troisième niveaux électriquement conducteur.

Chacune des cellules de connexion peut être telle que :
- selon la première configuration, plusieurs des premiers vias électriquement conducteurs sont disposés au niveau des coins des losanges formés par les portions de lignes conductrices des premier et troisième niveaux électriquement conducteurs et l'un des deuxièmes vias électriquement conducteurs est disposé au niveau de l'intersection des segments formés par les portions de lignes conductrices du deuxième niveau électriquement conducteur, ou
- selon la deuxième configuration, l'un des premiers vias électriquement conducteurs est disposé au niveau des intersections des segments formés par les portions de lignes conductrices des premier et troisième niveaux électriquement conducteurs et plusieurs des deuxièmes vias électriquement conducteurs sont disposés au niveau des coins du losange formé par les portions de lignes conductrices du deuxième niveau électriquement conducteur.

Selon une autre variante, chacune des cellules de connexion peut être telle que :
- les portions de lignes conductrices de chacun des premier et troisième niveaux électriquement conducteurs forment deux segments chacun sensiblement parallèle à deux des bords de cellule de connexion, se croisant sensiblement perpendiculairement l'un par rapport à l'autre au niveau d'une première intersection et dont les extrémités sont disposées au niveau des bords de la cellule de connexion ;
- les portions de lignes conductrices du deuxième niveau électriquement conducteur forment deux segments chacun sensiblement parallèle à deux des bords de la cellule de connexion, se croisant sensiblement perpendiculairement l'un par rapport à l'autre au niveau d'une deuxième intersection qui est, dans ledit plan, décalée par rapport aux premières intersections et dont les extrémités sont disposées au niveau des bords de la cellule de connexion.

Dans ce cas, les premiers vias électriquement conducteurs peuvent être disposés au niveau des premières intersections et les deuxièmes vias électriquement conducteurs peuvent être disposés au niveau des deuxièmes intersections.

Selon une autre variante, chacune des cellules de connexion peut être telle que :
- les portions de lignes conductrices de chacun des premier et troisième niveaux électriquement conducteurs forment deux premiers segments disposés au niveau de, et parallèlement à, deux premiers bords opposés de la cellule de connexion, et un deuxième segment s'étendant sensiblement perpendiculairement aux premiers segments et dont chacune des extrémités est disposée au niveau d'un des premiers bords ;
- les portions de lignes conductrices du deuxième niveau électriquement conducteur forment deux troisièmes segments disposés au niveau de, et parallèlement à, deux deuxièmes bords opposés de la cellule de connexion qui sont perpendiculaires aux premiers bords, et un quatrième segment s'étendant sensiblement perpendiculairement aux troisièmes segments et dont chacune des extrémités est disposée au niveau d'un des troisièmes bords.

Dans ce cas, chacune des cellules de connexion peut être telle que plusieurs des premiers vias électriquement conducteurs sont disposés au niveau de premières intersections entre le deuxième segment et les premiers segments formés par les portions de lignes conductrices des premier et troisième niveaux électriquement conducteurs, et telle que plusieurs deuxièmes vias électriquement conducteurs sont disposés au niveau de deuxièmes intersections entre le quatrième segment et les deuxièmes segments formés par les portions de lignes conductrices du deuxième niveau électriquement conducteur.

Le dispositif électronique peut être tel que :
- l'empilement comporte au moins quatre niveaux électriquement conducteurs disposés de manière alternée les uns au-dessus des autres tels que les motifs des lignes conductrices de deux niveaux espacés l'un de l'autre par un autre desdits niveaux soient similaires l'un de l'autre et forment des quadrillages, et
- les quadrillages de deux niveaux électriquement conducteurs successifs sont décalés l'un par rapport à l'autre tels que les premiers vias électriquement conducteurs relient électriquement les portions de lignes conductrices formant des premiers quadrillages à travers les ouvertures formées dans l'un ou plusieurs de deuxièmes quadrillages et que des deuxièmes vias électriquement conducteurs relient électriquement les portions de lignes conductrices formant les deuxièmes quadrillages à travers les ouvertures formées dans l'un ou plusieurs des premiers quadrillages.

La structure d'interconnexions peut comporter au moins une cellule de connexion dans laquelle au moins un des niveaux électriquement conducteurs est interrompu au niveau d'au moins un des côtés de la cellule de connexion telle qu'un signal destiné à se propager dans ledit un des niveaux électriquement conducteurs de cette cellule de connexion ne puisse pas être propagé dans une portion dudit au moins un des niveaux électriquement conducteurs d'au moins une autre cellule de connexion juxtaposée au dit au moins un des côtés de la cellule de connexion.

La structure d'interconnexions peut comporter au moins une cellule de connexion dans laquelle les portions de lignes conductrices d'au moins un des niveaux électriquement conducteurs sont reliées électriquement aux portions de lignes conductrices d'au moins un autre niveau électriquement conducteur adjacent de la cellule de connexion.

Un quadrillage correspond à une disposition qui comporte une juxtaposition de losanges, généralement des carrés.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent des structures d'interconnexions de l'art antérieur ;
- la figure 3 représente schématiquement un dispositif électronique, objet de la présente invention, selon un mode de réalisation particulier ;
- la figure 4 représente schématiquement une vue de dessus d'une partie des réseaux de lignes conductrices de la structure d'interconnexions d'un dispositif électronique, objet de la présente invention, selon un mode de réalisation particulier ;
- les figures 5A à 5D représentent schématiquement des exemples de réalisation de cellules de connexion servant à la réalisation de la structure d'interconnexions d'un dispositif électronique, objet de la présente invention ;
- les figures 6-9 représentent d'autres exemples de réalisation de cellules de connexion utilisées pour former une structure d'interconnexions d'un dispositif électronique, objet de la présente invention ;
- la figure 10 représente un assemblage de trois cellules de connexion juxtaposée formant une partie d'une structure d'interconnexions d'un dispositif électronique, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

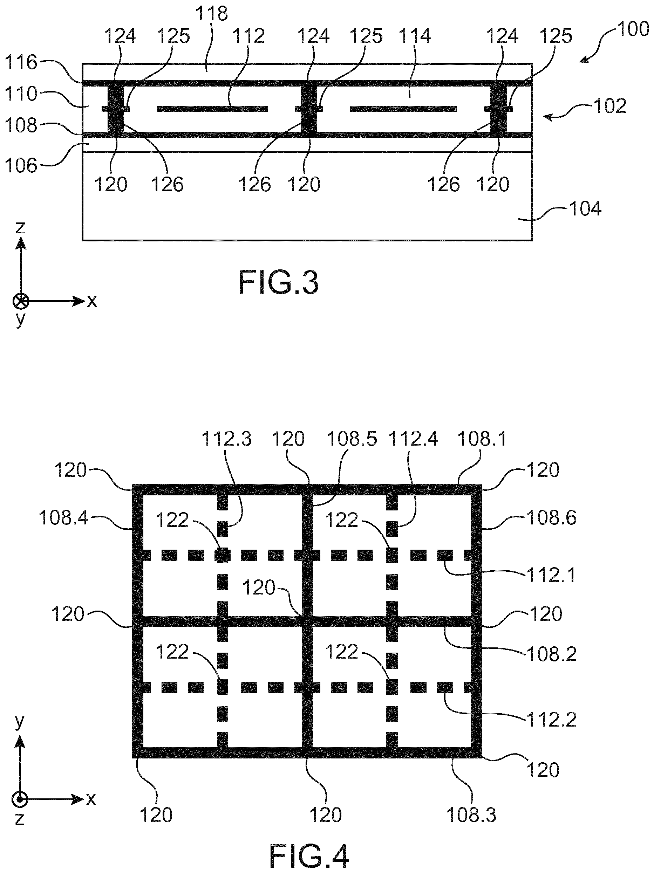

La figure 3 représente schématiquement une vue en coupe de côté d'un dispositif électronique 100 comportant une structure d'interconnexions électrique 102, selon un mode de réalisation particulier.

Le dispositif 100 comporte un circuit intégré 104, par exemple de type analogique RF.

La structure d'interconnexions électriques 102 est disposée sur le circuit intégré 104 et forme la partie back end du dispositif 100. La structure 102 est formée d'un empilement alterné de réseaux de lignes conductrices et de couches diélectriques (ILD). Sur l'exemple de la figure 3, la structure 102 comporte trois niveaux de métallisations formant chacun un des réseaux de lignes conductrices. Cet empilement comporte :
- une première couche diélectrique 106 disposée sur le circuit intégré 104 ;
- un premier niveau de métallisation formant un premier réseau de lignes conductrices 108 disposées sur la première couche diélectrique 106 ;
- une deuxième couche diélectrique 110 recouvrant le premier réseau de lignes conductrices 108 ;
- un deuxième niveau de métallisation formant un deuxième réseau de lignes conductrices 112 disposées sur la deuxième couche diélectrique 110 ;
- une troisième couche diélectrique 114 recouvrant le deuxième réseau de lignes conductrices 112 ;
- un troisième niveau de métallisation formant un troisième réseau de lignes conductrices 116 disposées sur la troisième couche diélectrique 114 ;
- une quatrième couche diélectrique 118 recouvrant le troisième réseau de lignes conductrices 116.

Une partie (non représentée) de la structure 102 est utilisée pour former les connexions électriques d'entrées/sortes du circuit intégré 104 ainsi que les connexions électriques entre les différents composants électroniques du circuit intégré 104. Une autre partie de la structure 102, décrite plus en détails ci-après, est utilisée pour acheminer un signal d'alimentation électrique et un potentiel de référence (masse) en différents points du circuit intégré 104. Dans l'exemple de réalisation décrit ici, les premier et troisième réseaux de lignes conductrices 108, 116 réalisent l'acheminement du signal d'alimentation électrique et le deuxième réseau de lignes conductrices 112 réalise l'acheminement du potentiel de référence.

Les réseaux de lignes conductrices 108, 112 et 116 sont tels que toutes les lignes conductrices d'un même réseau s'étendent dans un même plan (parallèle au plan (X,Y)) et forment un équipotentiel, c'est-à-dire que toutes les lignes conductrices d'un même réseau sont à un même potentiel électrique et distribuent un même signal électrique.

La figure 4 représente schématiquement une vue de dessus d'une partie des motifs formés par les réseaux de lignes conductrices de la structure d'interconnexions 102.

Les lignes conductrices 108 du premier réseau (représentées en traits pleins sur la figure 4) sont réalisées telles qu'elles forment, dans un plan dans lequel s'étendent les lignes conductrices 108 (correspondant au plan (X,Y) des figures 3 et 4), un premier motif correspondant à un premier quadrillage. Sur la figure 4, ce premier quadrillage est formé par le croisement de premières lignes conductrices 108.1, 108.2 et 108.3, s'étendant selon une première direction (parallèle à l'axe X), avec des deuxièmes lignes conductrices 108.4, 108.5 et 108.6 s'étendant selon une deuxième direction ici perpendiculaire à la première direction (selon l'axe Y). Les premières lignes conductrices 108.1, 108.2 et 108.3 du premier réseau croisent les deuxièmes lignes conductrices 108.4, 108.5, 108.6 du premier réseau en des premières intersections 120.

Les lignes conductrices 112 du deuxième réseau (représentées en traits pointillés sur la figure 4) sont réalisées telles qu'elles forment, dans un plan dans lequel s'étendent les lignes conductrices 112 (plan (X,Y)), un deuxième motif correspondant à un deuxième quadrillage. Sur la figure 4, ce deuxième quadrillage est formé par le croisement de premières lignes conductrices 112.1, 112.2 s'étendant selon la première direction avec des deuxièmes lignes conductrices 112.3, 112.4 s'étendant selon la deuxième direction. Les premières lignes conductrices 112.1, 112.2 du deuxième réseau croisent les deuxièmes lignes conductrices 112.3, 112.4 du deuxième réseau en des deuxièmes intersections 122.

Les quadrillages formés par les lignes conductrices 108 et 112 des premier et deuxième réseaux sont décalés l'un par rapport à l'autre tels que, vu de dessus (dans un plan parallèle au plan (X,Y)), les premières intersections 120 sont décalées, ou non alignées, par rapport aux deuxièmes intersections 122. Sur l'exemple de réalisation particulier décrit ici, les deuxièmes intersections 122 sont sensiblement alignées avec les centres des ouvertures, ou mailles, du premier quadrillage, et les premières intersections 120 sont sensiblement alignées avec les centres des ouvertures, ou mailles, du deuxième quadrillage. En outre, les ouvertures du premier quadrillage sont de dimensions (dans le plan (X,Y)) sensiblement similaires à celles du deuxième quadrillage.

Les lignes conductrices 116 du troisième réseau, non visibles sur la figure 4, sont réalisées telles qu'elles forment, dans un plan dans lequel s'étendent les lignes conductrices 116, un troisième motif similaire au premier motif formé par les lignes conductrices 108 du premier réseau et aligné avec le premier motif. Ainsi, lorsque la structure d'interconnexions 102 est vue de dessus, les lignes conductrices 116 du troisième réseau sont superposées aux lignes conductrices 108 du premier réseau et forment ainsi un troisième quadrillage similaire et superposé au premier quadrillage. Comme dans le premier réseau de lignes conductrices 108, le troisième quadrillage est formé par le croisement de premières lignes conductrices du troisième réseau s'étendant selon la première direction avec des deuxièmes lignes conductrices du troisième réseau s'étendant selon la deuxième direction. Les premières lignes conductrices du troisième réseau croisent les deuxièmes lignes conductrices du troisième réseau en des troisièmes intersections 124 qui sont alignées, parallèlement à l'axe Z, avec les premières intersections 120.

Les premier et troisième réseaux de lignes conductrices 108, 116 étant destinés à acheminer un même signal d'alimentation électrique, ces lignes conductrices 108, 116 sont reliées électriquement entre elles par des premiers vias conducteurs 126 formés avantageusement entre les premières et troisièmes intersections 120, 124, reliant ainsi les premières intersections 120 aux troisièmes intersections 106. Sur l'exemple de la figure 3, chaque premier via conducteur comporte une première portion conductrice traversant la deuxième couche diélectrique 110 et une deuxième portion conductrice traversant la troisième couche diélectrique 114. Les première et deuxième portions conductrices de chaque premier via sont ici reliées électriquement entre elles grâce à une autre portion électriquement conductrice 125 issue de la couche métallique servant à la réalisation du deuxième réseau de lignes conductrices 112, ces autres portions électriquement conductrices 125 étant isolées électriquement des lignes conductrices 112 du deuxième réseau.

En variante, les premiers vias conducteurs 126 peuvent s'étendre non pas entre les premières et troisièmes intersections 120, 124, mais entre des parties des lignes conductrices 108 et 116 des premier et troisième réseaux adjacentes aux premières et troisièmes intersections. Toutefois, les premiers vias conducteurs 126 sont disposés tels qu'ils ne sont pas électriquement en contact avec les lignes conductrices 112 du deuxième réseau, c'est-à-dire s'étendent entre les mailles du deuxième quadrillage formé par les lignes conductrices 112 du deuxième réseau sans venir en contact avec les lignes conductrices 112.

De manière avantageuse, des deuxièmes vias conducteurs, non visibles sur les figures 3 et 4, peuvent s'étendre depuis les deuxièmes intersections 122 (ou depuis des parties des lignes conductrices 112 adjacentes aux deuxièmes intersections 122) à travers les deuxièmes et troisièmes couches diélectriques 110, 114. Ces deuxièmes vias conducteurs sont disposés tels qu'ils ne sont pas en contact avec les lignes conductrices 108 et 116 des premier et troisième réseaux, c'est-à-dire s'étendent entre les mailles des premier et troisième quadrillages formés par les lignes conductrices 108, 1116 des premier et troisième réseaux. Ces deuxièmes vias conducteurs peuvent être en contact avec des portions électriquement conductrices issues de la couche métallique servant à la réalisation du premier réseau de lignes conductrices 108 et/ou avec des portions électriquement conductrices issues de la couche métallique servant à la réalisation du troisième réseau de lignes conductrices 116, ces portions électriquement conductrices étant isolées électriquement des lignes conductrices 108, 116 des premier et troisième réseaux.

La présence des premiers vias conducteurs 126 entre les mailles du deuxième quadrillage formé par les lignes conductrices 112 du deuxième réseau, et éventuellement des deuxièmes vias conducteurs entre les mailles des premier et troisième quadrillages formés par les lignes conductrices 108, 116 des premier et troisième réseaux, est très avantageuse car elle permet de former de très importantes capacités de découplage entre les différents réseaux de lignes conductrices destinés à acheminer des signaux différents, c'est-à-dire les premier et deuxième réseaux, et entre les deuxième et troisième réseaux.

Préalablement à la réalisation physique de la structure d'interconnexion 102, le motif général, ou « layout », de cette structure est conçu lors d'une étape de conception assistée par ordinateur du ou des chemins de conduction et/ou du ou des plans conducteurs destinés à être formés par la structure 102. La géométrie des réseaux de lignes conductrices de la structure 102 est avantageuse car elle peut être réalisée à partir de cellules de connexion individuelles qui, lorsqu'elles reliées électriquement entre elles en les disposant de manière adjacentes les unes des autres, permettent de former ce ou ces chemins de conduction et/ou ce ou ces plans conducteurs.

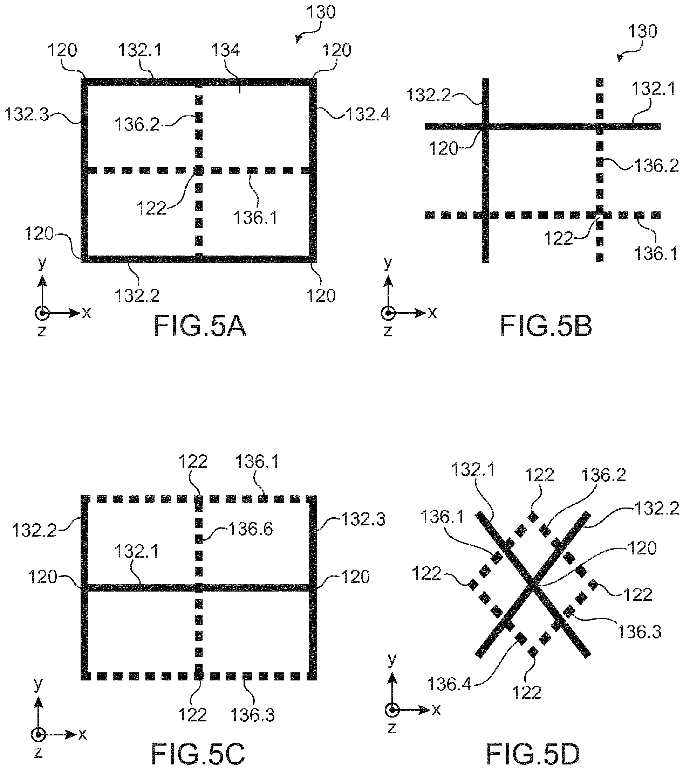

Un premier exemple de réalisation d'une telle cellule de connexion individuelle 130 est représenté sur la figure 5A.

Cette cellule 130 comporte deux portions 132.1 et 132.2 de lignes conductrices s'étendant selon une première direction (parallèlement à l'axe X) et deux portions 132.3 et 132.4 de lignes conductrices s'étendant selon une deuxième direction qui est ici sensiblement perpendiculaire à la première direction (parallèlement à l'axe Y). Ces portions 132.1 - 132.4 sont disposées au niveau des bords de la cellule 130 et délimitent donc latéralement la cellule 130. Les portions 132.1 - 132.4 forment un rectangle, avantageusement un carré, délimitant un espace vide 134. Ces portions 132.1 - 132.4 correspondent par exemple à des parties des lignes conductrices 108 du premier réseau ou des parties des lignes conductrices 116 du troisième réseau. Ainsi, les coins du rectangle formé par les portions 132.1 - 132.4 forment des intersections 120.

La cellule 130 comporte également deux portions 136.1 et 136.2 de lignes conductrices, l'une s'étendant selon la première direction et l'autre s'étendant selon la deuxième direction, se croisant sensiblement perpendiculairement l'une par rapport à l'autre en formant une intersection 122 en regard de l'espace vide 134 et dont les extrémités sont disposées au niveau des bords de la cellule 130. Ces portions 136.1, 136.2 définissent des parties des lignes conductrices 112 du deuxième réseau.

Enfin, la cellule 130 comporte également des portions de lignes conductrices, non visibles sur la figure 5A, superposées aux portions 132.1 - 132.4 et définissant des parties des lignes conductrices 116 du troisième réseau.

Ainsi, en juxtaposant plusieurs cellules 130 selon l'axe X et/ou l'axe Y, on obtient un motif définissant un ou plusieurs chemins de conduction électrique ou un ou plusieurs plans conducteurs formés par les différents niveaux de métallisation de la structure d'interconnexions 102. Par exemple, le motif représenté sur la figure 4 peut être obtenu en juxtaposant quatre cellules 130 selon un carré dont chaque côté est formé par deux cellules 130 juxtaposées.

Dans une telle cellule 130, quatre premiers vias conducteurs 126 peuvent être disposés au niveau des quatre intersections 120 et un deuxième via conducteur peut être formé au niveau de l'intersection 122.

Un deuxième exemple de réalisation d'une cellule de connexion individuelle 130 est représenté sur la figure 5B.

Cette cellule 130 comporte deux portions 132.1 et 132.2 de lignes conductrices, l'une s'étendant parallèlement à l'axe X et l'autre s'étendant parallèlement à l'axe Y, se croisant sensiblement perpendiculairement l'une avec l'autre au niveau d'une intersection 120 et dont les extrémités sont disposées au niveau des bords de la cellule 130. Ces portions 132.1 et 132.2 correspondent à des parties des lignes conductrices 108 du premier réseau.

La cellule 130 comporte également deux portions 136.1 et 136.2 de lignes conductrices, l'une s'étendant parallèlement à l'axe X et l'autre s'étendant parallèlement à l'axe Y, se croisant sensiblement perpendiculairement l'une avec l'autre au niveau d'une intersection 122 et dont les extrémités sont disposées au niveau des bords de la cellule 130. L'intersection 122 n'est pas superposée avec l'intersection 120. Ces portions 136.1, 136.2 définissent des parties des lignes conductrices 112 du deuxième réseau.

Enfin, la cellule 130 comporte également des portions de lignes conductrices, non visibles sur la figure 5B, superposées aux portions 132.1, 132.2 et correspondant à des parties des lignes conductrices 116 du troisième réseau.

Comme précédemment, en juxtaposant plusieurs cellules 130 selon l'axe X et/ou l'axe Y, on obtient un motif définissant un ou plusieurs chemins de conduction électrique et/ou un ou plusieurs plans conducteurs formés par les différents niveaux de métallisation de la structure d'interconnexions 102.

Dans une telle cellule 130, un premier via conducteur 126 peut être disposé au niveau de l'intersection 120 et un deuxième via conducteur peut être formé au niveau de l'intersection 122.

Un troisième exemple de réalisation d'une cellule de connexion 130 est représenté sur la figure 5C.

Cette cellule 130 comporte une portion 132.1 de ligne conductrice s'étendant parallèlement à l'axe X et deux portions 132.2 et 132.3 de lignes conductrices s'étendant parallèlement à l'axe Y. Les portions 132.2 et 132.3 sont disposées au niveau de deux premiers bords de la cellule 130, et les extrémités de la portion 132.1 sont disposées au niveau des deux premiers bords de la cellule 130. Les portions 132.2 et 132.3 croisent la portion 132.1 au niveau de deux intersections 120 se trouvant au niveau des deux premiers bords de la cellule 130. Ces portions 132.1 - 132.3 définissent des parties des lignes conductrices 108 du premier réseau.

La cellule 130 comporte également deux portions 136.1 et 136.3 de lignes conductrices s'étendant parallèlement à l'axe X et une portion 136.2 de ligne conductrice s'étendant parallèlement à l'axe Y. Les portions 136.1 et 136.3 sont disposées au niveau de deux deuxièmes bords de la cellule 130, et les extrémités de la portion 136.2 sont disposées au niveau des deux deuxièmes bords de la cellule 130. Les portions 136.1 et 136.3 croisent la portion 136.2 en deux intersections 122 se trouvant au niveau des deux deuxièmes bords de la cellule 130. Ces portions 136.1 - 136.3 définissent des parties des lignes conductrices 112 du deuxième réseau.

Enfin, la cellule 130 comporte également des portions de lignes conductrices, non visibles sur la figure 5C, superposées aux portions 132.1 - 132.3 et définissant des parties des lignes conductrices 116 du troisième réseau.

En juxtaposant plusieurs cellules 130 selon l'axe X et/ou l'axe Y, on obtient un motif définissant un ou plusieurs chemins de conduction et/ou un ou plusieurs plans conducteurs formés par les différents niveaux de métallisation de la structure d'interconnexions 102.

Dans une telle cellule 130, deux premiers vias conducteurs 126 peuvent être disposés au niveau des deux intersections 120 et deux deuxièmes vias conducteurs peuvent être formés au niveau des deux intersections 122.

Un quatrième exemple de réalisation d'une cellule de connexion 130 est représenté sur la figure 5D.

Cette cellule 130 comporte deux portions 132.1 et 132.2 de lignes conductrices dont les extrémités sont disposées au niveau des coins du rectangle formé par la cellule 130, et qui se croisent sensiblement au centre de la cellule 130 en formant une intersection 120. Ces portions 132.1 et 132.2 définissent des parties des lignes conductrices 108 du premier réseau.

La cellule 130 comporte également quatre portions 136.1 - 136.4 de lignes conductrices formant un losange dont chacun des sommets est disposé au niveau d'un des bords de la cellule 130. Chacun des sommets du losange formé par les portions 136.1 - 136.4 forme une intersection 122. Ces portions 136.1 - 136.4 définissent des parties des lignes conductrices 112 du deuxième réseau. Les portions 136.1 - 136.4 délimitent un espace vide en regard duquel se trouve l'intersection 120 des portions 132.1 et 132.2.

Enfin, la cellule 130 comporte également des portions de lignes conductrices, non visibles sur la figure 5D, superposées aux portions 132.1 et 132.2 et définissant des parties des lignes conductrices 116 du troisième réseau.

Ainsi, en juxtaposant plusieurs cellules 130 selon l'axe X et/ou l'axe Y, les portions de lignes conductrices 132.1 - 132.2 et 136.1 - 136.4 sont bien mises en contact les unes avec les autres au niveau de leurs extrémités, formant ainsi dans chacun des niveaux une ou plusieurs premières lignes conductrices s'étendant selon au moins une première direction et une ou plusieurs deuxièmes lignes conductrices croisant la ou les premières lignes conductrices, ces lignes conductrices formant un ou plusieurs chemins de conduction et/ou un ou plusieurs plans conducteurs formés par les différents niveaux de métallisation de la structure d'interconnexions 102.

Dans une telle cellule 130, cinq premiers vias conducteurs 126 peuvent être disposés au niveau de l'intersection 120 et des quatre extrémités des portions 132.1 et 132.2, et quatre deuxièmes vias conducteurs peuvent être disposés au niveau des sommets du losange défini par les portions 136.1 - 136.4.

Dans les différents exemples décrits ci-dessus en liaison avec les figures 5A à 5D, les portions des lignes conductrices atteignent les bords de la cellule 130 afin que la juxtaposition de plusieurs cellules 130 les unes à côté des autres, parallèlement à l'axe X et/ou à l'axe X, impliquent la mise en contact électrique de toutes les portions de lignes conductrices des cellules.

Le nombre de lignes conductrices se trouvant dans chacun des réseaux dépend de la surface destinée à être occupée par ces réseaux de lignes conductrices pour former le ou les chemins de conduction et/ou le ou les plans conducteurs du dispositif 100.

En variante du mode de réalisation précédemment décrit, le motif des premier et troisième réseaux de lignes conductrices et celui du deuxième réseau de lignes conductrices peuvent être inversés. Ainsi, en considérant par exemple la cellule 130 de la figure 5A, les portions 136 correspondant au deuxième réseau peuvent former un carré similaire à celui formé par les portions 132 représentées sur la figure 5A, et les portions 132 du premier réseau ainsi que celles du troisième réseau peuvent former un motif de croix similaire à celui formé par les portions 136 représentées sur la figure 5A.

Dans le mode de réalisation précédemment décrit, les lignes conductrices 108 du premier réseau sont reliées électriquement aux lignes conductrices 116 du troisième réseau par l'intermédiaire des premiers vias conducteurs 126. En variante, il est possible que les premiers vias conducteurs ne traversent qu'une partie de l'épaisseur d'au moins une des couches diélectriques 110 et 114, et donc que ces premiers vias conducteurs ne relient pas électriquement entre elles les lignes conductrices 108 du premier réseau aux lignes conductrices 116 du troisième réseau. Dans ce cas, la structure d'interconnexions 102 peut être apte à transmettre trois signaux électriques différents, chacun de ces signaux étant distribué par l'un des réseaux de lignes conductrices. Même dans cette configuration, les vias conducteurs sont utiles car ils forment des capacités parasites entre les réseaux et augmentent ainsi la capacité de découplage entre les différents signaux distribués.

En outre, dans le mode de réalisation particulier précédemment décrit, la structure 102 comporte trois niveaux de métallisation formant chacun un réseau de lignes conductrices. La structure 102 peut également comporter un nombre plus important de niveaux de métallisation, et donc de réseaux de lignes conductrices superposés. Dans ce cas, les motifs des lignes conductrices des réseaux supplémentaires sont similaires à ceux précédemment décrits pour les premier, deuxième et troisième réseaux et tels que, en considérant trois réseaux superposés successifs parmi l'ensemble des réseaux superposés, le motif du réseau se trouvant au milieu des trois est différent des motifs des deux autres réseaux et les motifs de ces deux autres réseaux sont similaires l'un de l'autre.

De plus, en considérant par exemple que les premiers vias conducteurs 126 sont reliés aux lignes conductrices d'un ou plusieurs des réseaux impairs (premier, troisième, etc.) et que les deuxièmes vias conducteurs sont reliés aux lignes conductrices d'un ou plusieurs des réseaux pairs (deuxième, quatrième, etc.), les motifs des lignes conductrices de ces réseaux sont tels que les premiers vias conducteurs s'étendent à travers un ou plusieurs des réseaux pairs sans être en contact électrique avec les lignes conductrices de ce ou ces réseaux pairs, et tels que les deuxièmes vias conducteurs s'étendent à travers un ou plusieurs des réseaux impairs sans être en contact électrique avec les lignes conductrices de ce ou ces réseaux impairs.

Tous les réseaux impairs de lignes électriques peuvent par exemple être destinés à distribuer le même signal d'alimentation électrique et tous les réseaux pairs de lignes électriques peuvent être destinés à distribuer un même potentiel de référence. Un nombre plus important de signaux électriques peuvent être distribués par la structure d'interconnexions selon que différents réseaux pairs ou impairs soient ou non reliés électriquement eux par les premiers et deuxièmes vias conducteurs.

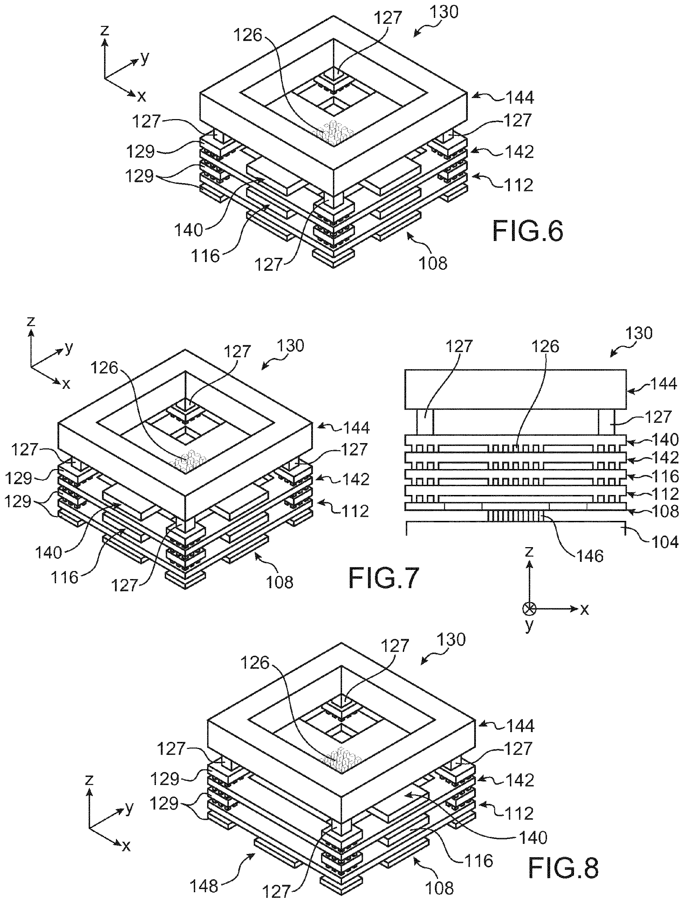

La figure 6 représente schématiquement une partie d'une structure 102 comportant six réseaux de lignes conductrices superposés, et qui correspond sur cette figure à une cellule de connexion 130.

Cette cellule 130 comporte des portions d'un premier réseau de lignes conductrices 108 dont le motif, dans cette cellule, correspond à celui des portions 136 précédemment décrit en liaison avec la figure 5A, c'est-à-dire un motif en forme de croix dont l'intersection se trouve sensiblement au centre de la cellule 130 dans le plan (X,Y). Les extrémités des portions du premier réseau de lignes conductrices 108 se trouvent au niveau des bords latéraux de la cellule 130. Des portions d'un deuxième réseau de lignes conductrices 112 sont réalisées selon le motif correspondant à celui des portions 132 précédemment décrit en liaison avec la figure 5A, c'est-à-dire un motif formant un carré, les portions étant disposées au niveau des bords latéraux de la cellule 130. La cellule 130 comporte également des portions d'un troisième réseau de lignes conductrices 116 et d'un cinquième réseau de lignes conductrices 140 dont le motif est similaire et superposé à celui des portions du premier réseau de lignes conductrices 108. Enfin, la cellule 130 comporte également des portions d'un quatrième réseau de lignes conductrices 142 et d'un sixième réseau de lignes conductrices 144 dont le motif est similaire et superposé à celui des portions du deuxième réseau de lignes conductrices 112.

Un premier via conducteur 126 passe sensiblement au centre de la cellule 130 et relie électriquement les portions des lignes conductrices 108, 116 et 140 des premier, troisième et cinquième réseaux. Il passe aux centres des carrés formés par les portions des deuxième et quatrième réseaux de lignes conductrices 112 et 142 sans venir en contact avec ces portions. De plus, ce premier via conducteur 126 est également en contact avec des portions conductrices (non visibles sur la figure 6) se trouvant aux mêmes niveaux que les deuxième et quatrième réseaux des lignes conductrices 112 et 142 mais qui ne sont pas reliées électriquement à ces lignes conductrices 112 et 142 (une telle portion conductrice correspond par exemple à la portion 125 précédemment décrite en liaison avec la figure 3). Ces portions conductrices sont issues des mêmes couches de métal que celles ayant servi à la réalisation des lignes conductrices 112 et 142.

Quatre deuxièmes vias conducteurs 127 traversent les différents réseaux de lignes conductrices à proximité des quatre coins de la cellule 130 et relient électriquement entre elles les portions des lignes conductrices 112, 142 et 144. Ces deuxièmes vias conducteurs 127 passent également par des portions conductrices 129 (sur la figure 6, les références 129 ne sont indiquées que pour les portions conductrices localisées au niveau d'un seul des quatre coins de la cellule 130) se trouvant aux mêmes niveaux que les premier, troisième et cinquième réseaux des lignes 108, 116, 140 mais qui ne sont pas reliées électriquement à ces lignes conductrices 108, 116, 140.

Cette cellule 130 est de forme parallélépipédique rectangle, ou cubique, et a par exemple des côtés de dimension (selon les axes X et Y) égale à environ 5 µm. Au sein de chacun des réseaux de lignes conductrices 108, 112, 116, 140, 142 et 144, les portions des lignes conductrices ont par exemple une largeur telle que la cellule 130 soit en accord avec la densité de métal minimale imposée par les règle de dessin de la structure d'interconnexions 102.

Les lignes conductrices 108, 116 et 140 sont par exemple destinées à distribuer un potentiel de référence et les lignes conductrices 112, 142 et 144 sont par exemple destinées à distribuer un signal d'alimentation électrique. Dans cette cellule 130, le potentiel de référence et le signal d'alimentation électrique sont accessibles, pour chacun des réseaux de lignes conductrices, au niveau des quatre faces latérales de la cellule 130. Ainsi, un ou plusieurs chemins de conduction et/ou un ou plusieurs plans conducteurs permettant la propagation du potentiel de référence et du signal d'alimentation peuvent être construits en juxtaposant plusieurs cellules 130 les unes à côté des autres selon l'axe X et/ou l'axe Y, les connexions électriques entre les portions de lignes conductrices des différentes cellules 130 étant obtenues par la mise en contact latéral de ces cellules 130.

Par exemple, la cellule 130 de la figure 6 permet d'obtenir une capacité d'environ 6,65 fF entre les deux ensembles de réseaux de lignes conductrices distribuant les deux signaux, c'est-à-dire entre le premier ensemble formé par les portions de lignes conductrices 108, 116 et 140 et le deuxième ensemble formé par les portions de lignes conductrices 112, 142 et 144.

En variante, il est possible que la structure 102 soit utilisée pour distribuer plus de deux signaux différents. Il est par exemple possible que dans une structure d'interconnexions 102 comportant six réseaux de lignes conductrices superposés :
- les premier, troisième et cinquième réseaux, dont les lignes conductrices sont reliées par des premiers vias conducteurs, servent à distribuer un même potentiel de référence ;
- les deuxième et quatrième réseaux, dont les lignes conductrices sont reliées par des deuxièmes vias conducteurs, servent à distribuer un premier signal d'alimentation ;
- un sixième réseau, dont les lignes conductrices ne sont pas reliées aux deuxième et quatrième réseaux par les deuxièmes vias conducteurs, servent à distribuer un deuxième signal d'alimentation.

La figure 7 représente un autre exemple de réalisation d'une cellule 130 permettant une telle distribution de trois signaux électriques différents.

Dans cette cellule 130, le premier réseau de lignes conductrices 108, qui est le plus proche du circuit intégré 104, est avantageusement utilisé pour distribuer le potentiel de référence du fait que ce premier réseau peur servir à polariser le substrat semiconducteur du circuit intégré 104 par l'intermédiaire de vias conducteurs 146 reliant le premier réseau de lignes conductrices 108 au substrat. Les deuxième, quatrième et sixième réseaux de lignes conductrices 112, 142 et 144 sont aptes à distribuer un premier signal électrique de potentiel différent du potentiel de référence, ces trois réseaux étant reliés électriquement entre eux par les deuxièmes vias 127 formés au niveau des coins de la cellule 130. Les troisième et cinquième réseaux de lignes conductrices 116 et 140 sont aptes à distribuer un deuxième signal électrique de potentiel différent de ceux du premier signal et du potentiel de référence. Pour cela, aucun via conducteur ne relie les portions de lignes conductrices 108 aux lignes conductrices 116 du troisième réseau.

Comme cela est visible sur la figure 7, les deuxièmes vias conducteurs 127 reliant les deuxième, quatrième et sixième réseaux de lignes conductrices 114, 142 et 144 sont également reliés à des portions conductrices 129 se trouvant au même niveau que les lignes conductrices 108, 116 et 140 des premier, troisième et cinquième réseaux, ces portions conductrices 129 n'étant pas reliées électriquement aux lignes conductrices 108, 116 et 140. Cela permet d'ajouter des capacités parasites latérales entre le premier signal électrique distribué par les réseaux de lignes conductrices 114, 142 et 144 et le potentiel de référence distribué par le réseau de lignes conductrices 108, et augmenter ainsi la capacité de découplage entre ces signaux. Cela permet également d'ajouter des capacités parasites latérales entre le premier signal électrique distribué par les réseaux de lignes conductrices 114, 142 et 144 et le deuxième signal électrique distribué par les troisième et cinquième réseaux de lignes conductrices 116, 140, et augmenter ainsi la capacité de découplage entre ces signaux.

Une capacité parasite existe également entre le deuxième signal distribué par les troisième et cinquième réseaux de lignes conductrices 116 et 140 et le potentiel de référence distribué par le premier réseau de lignes conductrices 108 en raison du vide présent au centre du carré formé par les portions de lignes conductrices 112 et du fait que les portions de lignes conductrices 108 sont superposées aux portions de lignes conductrices 112.

Ainsi, dans une telle cellule 130, une capacité de découplage existe entre tous les signaux distribués par la cellule 130, ce qui permet d'avoir une bonne stabilité des tensions continues distribuées et de réduire l'impédance totale liée à la distribution des signaux électriques d'alimentation, de polarisation ou de référence dans les différents niveaux conducteurs de la cellule 130.

Les cellules 130 peuvent comporter un nombre plus important de réseaux de lignes conductrices superposés pour distribuer un plus grand nombre de signaux différents.

Le ou les chemins de conduction et/ou le plan conducteur formé dans la structure d'interconnexions 102 peuvent être entièrement réalisés en juxtaposant des cellules de connexions 130 telles que par exemple décrites en liaison avec les figures 6 ou 7.

Il est parfois nécessaire que dans un chemin de conduction ou dans un plan conducteur, la distribution d'un ou plusieurs des signaux soit interrompue ponctuellement ou dans une partie de la structure 102. Pour cela, il est possible de faire appel à une ou plusieurs cellules de connexion 130 dans lesquelles, au niveau d'un ou plusieurs des réseaux de lignes conductrices, une ou plusieurs portions de lignes conductrices sont supprimées ou sont réalisées telles qu'elles n'atteignent pas un ou plusieurs bords de la cellule 130 afin que la distribution d'un ou plusieurs signaux soit interrompue au niveau de ce ou ces bords de la cellule 130.

Une telle cellule 130 est par exemple représentée sur la figure 8. Sur cette figure, les portions de lignes conductrices 116 et 140 sont partiellement gravées telles qu'elles n'atteignent pas une face latérale 148 de la cellule 130. Ainsi, si cette cellule est apte à distribuer un potentiel de référence et deux signaux d'alimentation comme précédemment décrit en liaison avec la figure 7, la distribution de ces trois signaux est assurée sur toutes les faces latérales de la cellule 130 sauf au niveau de la face latérale 148 au niveau de laquelle la distribution du signal acheminé par les réseaux de lignes conductrices 116 et 140 est interrompue au niveau de cette face latérale 148.

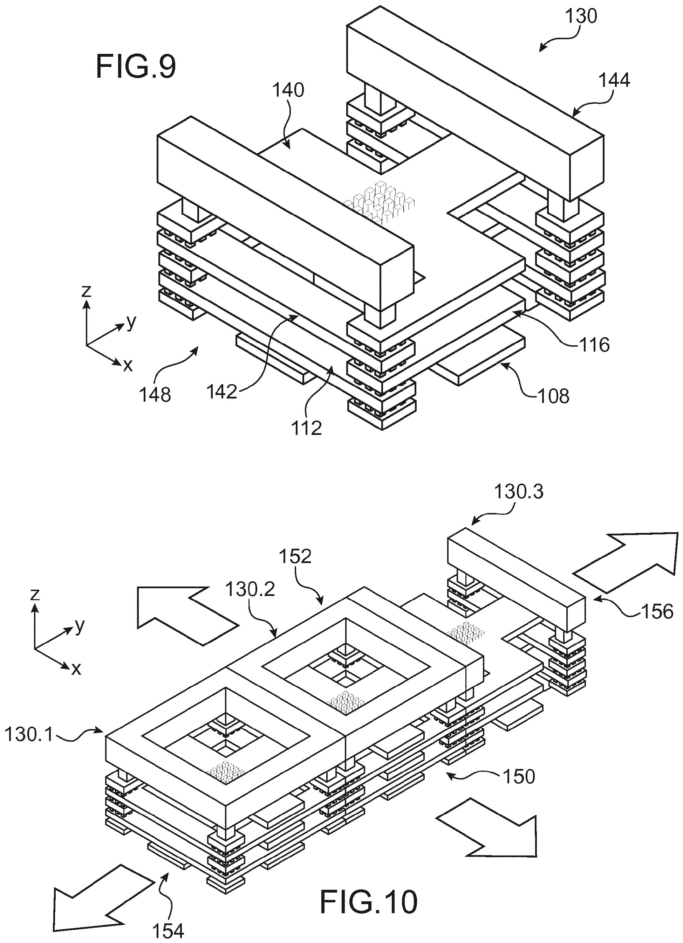

D'autres types de cellules 130 peuvent également être insérées dans le ou les chemins de conduction et/ou le ou les plans conducteurs afin de modifier l'attribution des niveaux de lignes conductrices de la structure 102 sur lesquels les signaux sont distribués. Un exemple de réalisation d'une telle cellule 130 est représenté sur la figure 9. Dans cette cellule, les lignes conductrices 116 et 140 des troisièmes et cinquièmes niveaux forment un motif en « Y » tel que ces lignes sont reliées électriquement aux lignes conductrices 112, 142 et 144 des deuxième, quatrième et sixième réseaux par l'intermédiaire des vias conducteurs 127 réalisés au niveau des quatre coins de la cellule 130. De plus, les motifs formés par les lignes conductrices 112, 142 et 144 ne correspondent pas à des carrés mais à deux portions distinctes non reliées électriquement entre elles. Ainsi, avec cette cellule 130, lorsque sa face latérale 148 reçoit un potentiel de référence sur les lignes conductrices 108, un premier signal électrique sur les lignes conductrices 112, 142 et 144 et un deuxième signal électrique sur les lignes conductrices 116 et 140, cette cellule permet la distribution, au niveau des autres faces latérales de la cellule 130, du potentiel de référence sur les lignes conductrices 108 et le deuxième signal électrique sur les lignes conductrices 116, 140.

La figure 10 représente la juxtaposition de trois cellules 130.1, 130.2 et 130.3. La première cellule 130.1 est similaire à la cellule 130 précédemment décrite en liaison avec la figure 8, la deuxième cellule 130.2 est similaire à la cellule 130 précédemment décrite en liaison avec la figure 7 et la troisième cellule 130.3 est similaire à celle précédemment décrite en liaison avec la figure 9. Avec un tel assemblage de cellules 130, la distribution du potentiel de référence et des deux signaux électriques d'alimentation est réalisée de la manière suivante :
- sur les faces latérales 150 et 152 des cellules 130.1 et 130.2, les lignes conductrices 108 distribuent le potentiel de référence, les lignes conductrices 116 et 140 distribuent le premier signal électrique d'alimentation et les lignes conductrices 112, 142 et 144 distribuent le deuxième signal électrique d'alimentation ;
- sur la face latérale 154 de la cellule 130.1, les lignes conductrices 108 distribuent le potentiel de référence, les lignes conductrices 112, 142 et 144 distribuent le deuxième signal électrique d'alimentation, et les lignes conductrices 116 et 140 ne distribuent aucun signal ;
- sur les faces latérales 150, 152 et 156 de la cellule 130.3, les lignes conductrices 108 distribuent le potentiel de référence, les lignes conductrices 116 et 140 distribuent le deuxième signal électrique d'alimentation, et les lignes conductrices 112, 142 et 144 ne distribuent aucun signal.

## Revendications

1. Dispositif électronique (100) comportant une structure d'interconnexions électriques (102) formant au moins un chemin de conduction électrique entre au moins deux points du dispositif électronique (100) et/ou au moins un plan électriquement conducteur, et comportant un empilement alterné de réseaux de lignes conductrices (108, 112, 116) et de couches diélectriques (106, 110, 114, 118) dans lequel :
- toutes les lignes conductrices (108, 112, 116) d'un même réseau s'étendent dans un même plan et forment un equipotentiel ;
- un premier motif des lignes conductrices (108) d'un premier réseau est tel qu'au moins une première des lignes conductrices (108.1, 108.2, 108.3) du premier réseau s'étend selon au moins une première direction et plusieurs deuxièmes des lignes conductrices (108.4, 108.5, 108.6) du premier réseau croisent la première des lignes conductrices (108.1, 108.2, 108.3) du premier réseau en plusieurs intersections (120) ;
- un troisième motif des lignes conductrices (116) d'un troisième réseau est similaire au premier motif, les premier et troisième motifs étant superposés l'un au-dessus de l'autre et tels que les intersections (120) du premier motif sont alignées avec les intersections (124) du troisième motif selon un axe sensiblement perpendiculaire aux plans dans lesquels s'étendent les lignes conductrices (108, 116) des premier et troisième réseaux ;
- un deuxième motif des lignes conductrices (112) d'un deuxième réseau disposé entre les premier et troisième réseaux de lignes conductrices (108, 116) est tel qu'au moins une première des lignes conductrices (112.1, 112.2) du deuxième réseau s'étend selon la première direction et plusieurs deuxièmes des lignes conductrices (112.3, 112.4) du deuxième réseau croisent la première des lignes conductrices (112.1, 112.2) du deuxième réseau en plusieurs intersections (122) décalées par rapport aux intersections (120, 124) des premier et troisième motifs ;
- au moins un premier via conducteur (126) s'étend à travers au moins une partie d'au moins une des couches diélectriques (110, 114) interposées entre les premier et troisième réseaux de lignes conductrices (108, 116), est en contact avec au moins une des lignes conductrices (108, 116) du premier réseau et/ou du troisième réseau et est tel qu'une section du premier via conducteur (126) projetée dans un plan par lequel passent les lignes conductrices (112) du deuxième réseau n'est pas en contact avec les lignes conductrices (112) du deuxième réseau.

2. Dispositif électronique (100) selon la revendication 1, comportant plusieurs premiers vias conducteurs (126) s'étendant à travers les couches diélectriques (110, 114) interposées entre les premier et troisième réseaux de lignes conductrices (108, 116) et reliant chacun électriquement une des intersections (120) du premier réseau de lignes conductrices (108) à une des intersections (124) du troisième réseau de lignes conductrices (116) par l'intermédiaire d'une portion conductrice (125) du deuxième réseau qui est isolée électriquement des lignes conductrices (112) du deuxième réseau.

3. Dispositif électronique (100) selon l'une des revendications précédentes, comportant en outre au moins un deuxième via conducteur (127) s'étendant à travers au moins une partie d'au moins une des couches diélectriques (110, 114) interposées entre les premier et troisième réseaux de lignes conductrices (108, 116), en contact avec au moins une des lignes conductrices (112) du deuxième réseau et tel qu'une section du deuxième via conducteur (127) projetée dans un plan par lequel passent les lignes conductrices (108) du premier réseau n'est pas en contact avec les lignes conductrices (108) du premier réseau.

4. Dispositif électronique (100) selon la revendication 3, comportant plusieurs deuxièmes vias conducteurs (127) s'étendant à travers les couches diélectriques (110, 114) interposées entre les premier et troisième réseaux de lignes conductrices (108, 116), chacun étant en contact avec une des intersections (122) du deuxième réseau de lignes conductrices (112) et avec une portion conductrice (129) du premier réseau qui est isolée électriquement des lignes conductrices (108) du premier réseau et/ou une portion conductrice (129) du troisième réseau qui est isolée électriquement des lignes conductrices (116) du troisième réseau.

5. Dispositif électronique (100) selon l'une des revendications précédentes, dans lequel les premier et troisième motifs des lignes conductrices (108, 116) des premier et troisième réseaux correspondent respectivement à un premier et un troisième quadrillages alignés et superposés l'un au-dessus de l'autre, et dans lequel le deuxième motif des lignes conductrices (112) du deuxième réseau correspond à un deuxième quadrillage décalé par rapport aux premier et troisième quadrillages.

6. Dispositif électronique (100) selon les revendications 2, 4 et 5, dans lequel les premiers vias conducteurs (126) traversent des ouvertures formées dans le deuxième quadrillage et les deuxièmes vias conducteurs traversent des ouvertures (134) formées dans au moins l'un des premier et troisième quadrillages.

7. Dispositif électronique (100) selon l'une des revendications précédentes, dans lequel les lignes conductrices (108, 112, 116) d'un même réseau se croisent de manière sensiblement perpendiculaire.

8. Dispositif électronique (100) selon l'une des revendications précédentes, dans lequel au moins une des premières des lignes conductrices (108.1, 108.2, 108.3, 112.1, 112.2) d'un des réseaux est interrompue.

9. Dispositif électronique (100) selon l'une des revendications précédentes, comportant en outre un ou plusieurs autres réseaux de lignes conductrices superposés aux premier, deuxième et troisième réseaux de lignes conductrices (108, 112, 116) et dont les lignes conductrices forment un motif similaire et aligné au premier ou au deuxième motif tel que les motifs formés par les lignes conductrices (108, 112, 116) de l'ensemble des réseaux correspondent une superposition alternée des premier et deuxième motifs.

10. Dispositif électronique (100) selon l'une des revendications précédentes, comportant en outre au moins un circuit intégré analogique (104) et dans lequel la structure d'interconnexions (102) forme des plans de masse et d'alimentation électrique dudit au moins un circuit intégré analogique (104).

11. Procédé de réalisation d'un dispositif électronique (100) comportant une structure d'interconnexions électriques (102) formant au moins un chemin de conduction électrique entre au moins deux points du dispositif électronique (100) et/ou au moins un plan électriquement conducteur, dans lequel le procédé comporte une étape de conception assistée par ordinateur du chemin de conduction électrique et/ou du plan électriquement conducteur à partir de plusieurs cellules de connexion (130) similaires modélisant chacune une partie d'un empilement alterné de réseaux de lignes conductrices (108, 112, 116) et de couches diélectriques (106, 110, 114, 118) dans lequel :
- toutes les lignes conductrices (108, 112, 116) d'un même réseau s'étendent dans un même plan et forment un equipotentiel ;
- un premier motif des lignes conductrices (108) d'un premier réseau est tel qu'au moins une première des lignes conductrices (108.1, 108.2, 108.3) du premier réseau s'étend selon au moins une première direction et plusieurs deuxièmes des lignes conductrices (108.4, 108.5, 108.6) du premier réseau croisent la première des lignes conductrices (108.1, 108.2, 108.3) du premier réseau en plusieurs intersections (120) ;
- un troisième motif des lignes conductrices (116) d'un troisième réseau est similaire au premier motif, les premier et troisième motifs étant superposés l'un au-dessus de l'autre et tels que les intersections (120) du premier motif sont alignées avec les intersections (124) du troisième motif selon un axe sensiblement perpendiculaire aux plans dans lesquels s'étendent les lignes conductrices (108, 116) des premier et troisième réseaux ;
- un deuxième motif des lignes conductrices (112) d'un deuxième réseau disposé entre les premier et troisième réseaux de lignes conductrices (108, 116) est tel qu'au moins une première des lignes conductrices (112.1, 112.2) du deuxième réseau s'étend selon la première direction et plusieurs deuxièmes des lignes conductrices (112.3, 112.4) du deuxième réseau croisent la première des lignes conductrices (112.1, 112.2) du deuxième réseau en plusieurs intersections (122) décalées par rapport aux intersections (120, 124) des premier et troisième motifs ;
- au moins un premier via conducteur (126) s'étend à travers au moins une partie d'au moins une des couches diélectriques (110, 114) interposées entre les premier et troisième réseaux de lignes conductrices (108, 116), est en contact avec au moins une des lignes conductrices (108, 116) du premier réseau et/ou du troisième réseau et tel qu'une section du premier via conducteur (126) projetée dans un plan par lequel passent les lignes conductrices (112) du deuxième réseau n'est pas en contact avec les lignes conductrices (112) du deuxième réseau ;
et dans lequel, lors de l'étape de conception assistée par ordinateur du chemin de conduction électrique et/ou du plan électriquement conducteur, une pluralité de cellules de connexion (130) sont juxtaposées et mises en contact latéralement les unes aux autres pour former le chemin de conduction électrique et/ou le plan électriquement conducteur.

12. Procédé selon la revendication 11, dans lequel les premier et troisième motifs des lignes conductrices (108, 116) des premier et troisième réseaux correspondent à un premier et un troisième quadrillages alignés l'un au-dessus de l'autre, et dans lequel le deuxième motif des lignes conductrices (112) du deuxième réseau correspond à un deuxième quadrillage décalé par rapport aux premier et troisième quadrillages.

13. Procédé selon l'une des revendications 11 ou 12, dans lequel chacune des cellules de connexion (130) est telle qu'au moins une des lignes conductrices (108, 112, 116) de chacun des réseaux s'étend entre un premier coin ou un premier bord de la cellule de connexion (130) et un deuxième coin ou un deuxième bord de la cellule de connexion (130).

14. Procédé selon l'une des revendications 11 à 13, dans lequel chacune des cellules de connexion (130) comporte au moins une partie de la première des lignes conductrices (108, 112, 116) et au moins une des deuxièmes des lignes conductrices (108, 112, 116) de chacun des réseaux.

## Patentansprüche

1. Elektronische Vorrichtung (100), umfassend eine elektrische Verbindungsstruktur (102), die wenigstens einen elektrischen Leitungsweg zwischen wenigstens zwei Punkten der elektronischen Vorrichtung (100) und/oder wenigstens eine elektrisch leitfähige Ebene bildet, und umfassend einen alternierenden Stapel von Netzen von leitfähigen Leitungen (108, 112, 116) und von dielektrischen Schichten (106, 110, 114, 118), wobei:
- alle leitfähigen Leitungen (108, 112, 116) ein und desselben Netzes sich in ein und derselben Ebene erstrecken und ein Äquipotential bilden;
- ein erstes Motiv von leitfähigen Leitungen (108) eines ersten Netzes derart ist, dass wenigstens eine erste der leitfähigen Leitungen (108.1, 108.2, 108.3) des ersten Netzes sich entlang wenigstens einer ersten Richtung erstreckt, und mehrere zweite der leitfähigen Leitungen (108.4, 108.5, 108.6) des ersten Netzes die erste der leitfähigen Leitungen (108.1, 108.2, 108.3) des ersten Netzes an mehreren Schnittpunkten (120) schneiden;
- ein drittes Motiv der leitfähigen Leitungen (116) eines dritten Netzes dem ersten Motiv ähnlich ist, wobei das erste und das dritte Motiv übereinander überlagert sind und derart, dass die Schnittpunkte (120) des ersten Motivs mit den Schnittpunkten (124) des dritten Motivs entlang einer Achse im Wesentlichen orthogonal zu den Ebenen ausgerichtet sind, in denen sich die leitfähigen Leitungen (108, 116) des ersten und des dritten Netzes erstrecken;
- ein zweites Motiv der leitfähigen Leitungen (112) eines zweiten Netzes, das zwischen dem ersten und dem dritten Netz von leitfähigen Leitungen (108, 116) angeordnet ist, derart ist, dass wenigstens eine erste der leitfähigen Leitungen (112.1, 112.2) des zweiten Netzes sich entlang der ersten Richtung erstreckt, und mehrere zweite der leitfähigen Leitungen (112.3, 112.4) des zweiten Netzes die erste der leitfähigen Leitungen (112.1, 112.2) des zweiten Netzes an mehreren Schnittpunkten (122) schneiden, die bezüglich der Schnittpunkte (120, 124) des ersten und des dritten Motivs versetzt sind;
- wenigstens ein erster leitfähiger Pfad (126) sich durch wenigstens einen Teil von wenigstens einer der dielektrischen Schichten (110, 114) erstreckt, die zwischen dem ersten und dem dritten Netz von leitfähigen Leitungen (108, 116) eingefügt sind, in Kontakt mit wenigstens einer der leitfähigen Leitungen (108, 116) des ersten Netzes und/oder des dritten Netzes ist, und derart ist, dass ein Abschnitt des ersten leitfähigen Pfads (126), projiziert in eine Ebene, durch die die leitfähigen Leitungen (112) des zweiten Netzes verlaufen, nicht in Kontakt mit den leitfähigen Leitungen (112) des zweiten Netzes ist.

2. Elektronische Vorrichtung (100) nach Anspruch 1, umfassend mehrere erste leitfähige Pfade (126), die sich durch die dielektrischen Schichten (110, 114) erstrecken, die zwischen dem ersten und dem dritten Netz von leitfähigen Leitungen (108, 116) eingefügt sind, und jeweils elektrisch einen der Schnittpunkte (120) des ersten Netzes von leitfähigen Leitungen (108) mit einem der Schnittpunkte (124) des dritten Netzes von leitfähigen Leitungen (116) mittels eines leitfähigen Bereichs (125) des zweiten Netzes verbinden, der elektrisch von den leitfähigen Leitungen (112) des zweiten Netzes isoliert ist.

3. Elektronische Vorrichtung (100) nach einem der vorhergehenden Ansprüche, ferner umfassend wenigstens einen zweiten leitfähigen Pfad (127), der sich durch wenigstens einen Teil von wenigstens einer der dielektrischen Schichten (110, 114) erstreckt, die zwischen dem ersten und dem dritten Netz von leitfähigen Leitungen (108, 116) eingefügt sind, in Kontakt mit wenigstens einer der leitfähigen Leitungen (112) des zweiten Netzes und derart, dass ein Abschnitt des zweiten leitfähigen Pfads (127), projiziert in eine Ebene, durch die die leitfähigen Leitungen (108) des ersten Netzes verlaufen, nicht in Kontakt mit den leitfähigen Leitungen (108) des ersten Netzes ist.

4. Elektronische Vorrichtung (100) nach Anspruch 3, umfassend mehrere zweite leitfähige Pfade (127), die sich durch die dielektrischen Schichten (110, 114) erstrecken, die zwischen dem ersten und dem dritten Netz von leitfähigen Leitungen (108, 116) eingefügt sind, wobei jeder in Kontakt mit einem der Schnittpunkte (122) des zweiten Netzes von leitfähigen Leitungen (112) und mit einem leitfähigen Bereich (129) des ersten Netzes ist, der elektrisch von den leitfähigen Leitungen (108) des ersten Netzes isoliert ist, und/oder einem leitfähigen Bereich (129) des dritten Netzes, der elektrisch von den leitfähigen Leitungen (116) des dritten Netzes isoliert ist.

5. Elektronische Vorrichtung (100) nach einem der vorhergehenden Ansprüche, bei der das erste und das dritte Motiv der leitfähigen Leitungen (108, 116) des ersten und des dritten Netzes einem ersten beziehungsweise einem dritten Raster entsprechen, die ausgerichtet und übereinander überlagert sind, und wobei das zweite Motiv der leitfähigen Leitungen (112) des zweiten Netzes einem zweiten Raster entspricht, das bezüglich des ersten und des dritten Rasters versetzt ist.

6. Elektronische Vorrichtung (100) nach den Ansprüchen 2, 4 und 5, wobei die ersten leitfähigen Pfade (126) Öffnungen durchsetzen, die in dem zweiten Raster gebildet sind, und die zweiten leitfähigen Pfade Öffnungen (134) durchsetzen, die in wenigstens einem von dem ersten und dem dritten Raster gebildet sind.

7. Elektronische Vorrichtung (100) nach einem der vorhergehenden Ansprüche, wobei die leitfähigen Leitungen (108, 112, 116) ein und desselben Netzes sich im Wesentlichen orthogonal schneiden.

8. Elektronische Vorrichtung (100) nach einem der vorhergehenden Ansprüche, wobei wenigstens eine von den ersten von den leitfähigen Leitungen (108.1, 108.2, 108.3, 112.1, 112.2) eines der Netze unterbrochen ist.

9. Elektronische Vorrichtung (100) nach einem der vorhergehenden Ansprüche, ferner umfassend ein oder mehrere andere Netze von leitfähigen Leitungen, die dem ersten, zweiten und dritten Netz von leitfähigen Leitungen (108, 112, 116) überlagert sind, und deren leitfähige Leitungen ein Motiv ähnlich zu und ausgerichtet mit dem ersten oder dem zweiten Motiv bilden, derart, dass die Motive, die durch die leitfähigen Leitungen (108, 112, 116) der Gesamtheit der Netze gebildet sind, einer alternierenden Überlagerung des ersten und des zweiten Motivs entsprechen.

10. Elektronische Vorrichtung (100) nach einem der vorhergehenden Ansprüche, ferner umfassend wenigstens eine analoge integrierte Schaltung (104), und wobei die Verbindungsstruktur (102) Masse- und elektrische Versorgungsebenen der wenigstens einen analogen integrierten Schaltung (104) bildet.

11. Verfahren zur Herstellung einer elektronischen Vorrichtung (100), umfassend eine elektrische Verbindungsstruktur (102), die wenigstens einen elektrischen Leitungsweg zwischen wenigstens zwei Punkten der elektronischen Vorrichtung (100) und/oder wenigstens eine elektrisch leitfähige Ebene bildet, wobei das Verfahren einen computerunterstützten Schritt des Entwerfens des elektrischen Leitungswegs und/oder der elektrischen leitfähigen Ebene ausgehend von mehreren ähnlichen Verbindungszellen (130) umfasst, die jeweils einen Teil eines alternierenden Stapels von Netzen von leitfähigen Leitungen (108, 112, 116) und von dielektrischen Schichten (106, 110, 114, 118) modelieren, wobei:
- alle leitfähigen Leitungen (108, 112, 116) ein und desselben Netzes sich in ein und derselben Ebene erstrecken und ein Äquipotential bilden;
- ein erstes Motiv von leitfähigen Leitungen (108) eines ersten Netzes derart ist, dass wenigstens eine erste der leitfähigen Leitungen (108.1, 108.2, 108.3) des ersten Netzes sich entlang wenigstens einer ersten Richtung erstreckt, und mehrere zweite der leitfähigen Leitungen (108.4, 108.5, 108.6) des ersten Netzes die erste der leitfähigen Leitungen (108.1, 108.2, 108.3) des ersten Netzes an mehreren Schnittpunkten (120) schneiden;
- ein drittes Motiv der leitfähigen Leitungen (116) eines dritten Netzes dem ersten Motiv ähnlich ist, wobei das erste und das dritte Motiv übereinander überlagert sind und derart, dass die Schnittpunkte (120) des ersten Motivs mit den Schnittpunkten (124) des dritten Motivs entlang einer Achse im Wesentlichen orthogonal zu den Ebenen ausgerichtet sind, in denen sich die leitfähigen Leitungen (108, 116) des ersten und des dritten Netzes erstrecken;
- ein zweites Motiv der leitfähigen Leitungen (112) eines zweiten Netzes, das zwischen dem ersten und dem dritten Netz von leitfähigen Leitungen (108, 116) angeordnet ist, derart ist, dass wenigstens eine erste der leitfähigen Leitungen (112.1, 112.2) des zweiten Netzes sich entlang der ersten Richtung erstreckt, und mehrere zweite der leitfähigen Leitungen (112.3, 112.4) des zweiten Netzes die erste der leitfähigen Leitungen (112.1, 112.2) des zweiten Netzes an mehreren Schnittpunkten (122) schneiden, die bezüglich der Schnittpunkte (120, 124) des ersten und des dritten Motivs versetzt sind;
- wenigstens ein leitfähiger Pfad (126) sich durch wenigstens einen Teil von wenigstens einer der dielektrischen Schichten (110, 114) erstreckt, die zwischen dem ersten und dem dritten Netz von leitfähigen Leitungen (108, 116) eignefügt sind, in Kontakt mit wenigstens einer der leitfähigen Leitungen (108, 116) des ersten Netzes und/oder des dritten Netzes ist, und derart ist, dass ein Abschnitt des ersten leitfähigen Pfads (126), projiziert in eine Ebene, durch die die leitfähigen Leitungen (112) des zweiten Netzes verlaufen, nicht in Kontakt mit den leitfähigen Leitungen (112) des zweiten Netzes ist;
und wobei während des Schritts des computerunterstützten Entwerfens des elektrischen Leitungswegs und/oder der elektrisch leitfähigen Ebene eine Mehrzahl von Verbindungszellen (130) nebeneinander positioniert und lateral miteinander in Kontakt gebracht werden, um den elektrischen Leitungsweg und/oder die elektrisch leitfähige Ebene zu bilden.

12. Verfahren nach Anspruch 11, bei der das erste und das dritte Motiv der leitfähigen Leitungen (108, 116) des ersten und des dritten Netzes einem ersten beziehungsweise einem dritten Raster entsprechen, die miteinander übereinander ausgerichtet ind, und wobei das zweite Motiv der leitfähigen Leitungen (112) des zweiten Netzes einem zweiten Raster entspricht, das bezüglich des ersten und des dritten Rasters versetzt ist.

13. Verfahren nach einem der Ansprüche 11 oder 12, wobei jede der Verbindungszellen (130) derart ist, dass wenigstens eine der leitfähigen Leitungen (108, 112, 116) von jedem der Netze sich zwischen einer ersten Ecke oder einem ersten Rand der Verbindungszelle (130) und einer zweiten Ecke oder einem zweiten Rand der Verbindungszelle (130) erstreckt.

14. Verfahren nach einem der Ansprüche 11 bis 13, wobei jede der Verbindungszellen (130) wenigstens einen Teil von der ersten der leitfähigen Leitungen (108, 112, 116) und wenigstens eine von den zweiten der leitfähigen Leitungen (108, 112, 116) von jedem der Netze umfasst.

## Claims

1. Electronic device (100) comprising an electrical interconnection structure (102) forming at least one electrical conduction path between at least two points of the electronic device (100) and/or at least one electrically conducting plane, and comprising an alternating stack of arrays of conducting lines (108, 112, 116) and dielectric layers (106, 110, 114, 118) in which:
- all the conducting lines (108, 112, 116) of a same array extend in a same plane and form an equipotential;
- a first pattern of the conducting lines (108) of a first array is such that at least one first of the conducting lines (108.1, 108.2, 108.3) of the first array extends along at least one first direction and several second of the conducting lines (108.4, 108.5, 108.6) of the first array intersect the first of the conducting lines (108.1, 108.2, 108.3) of the first array at several intersections (120);
- a third pattern of the conducting lines (116) of a third array is similar to the first pattern, the first and third patterns being superimposed one on top of the other and such that the intersections (120) of the first pattern are aligned with the intersections (124) of the third pattern along an axis substantially perpendicular to the planes in which the conducting lines (108, 116) of the first and third arrays extend;
- a second pattern of conducting lines (112) of a second array arranged between the first and third arrays of conducting lines (108, 116) is such that at least one first of the conducting lines (112.1, 112.2) of the second array extends along the first direction and several second of the conducting lines (112.3, 112.4) of the second array intersect the first of the conducting lines (112.1, 112.2) of the second array at several intersections (122) offset with respect to the intersections (120, 124) of the first and third patterns;
- at least one first conducting via (126) extends through at least one part of at least one of the dielectric layers (110, 114) interposed between the first and third arrays of conducting lines (108, 116), is in contact with at least one of the conducting lines (108, 116) of the first array and/or of the third array and is such that a section of the first conducting via (126) projected in a plane in which the conducting lines (112) of the second array pass is not in contact with the conducting lines (112) of the second array.

2. Electronic device (100) according to claim 1, comprising several first conducting vias (126) extending through the dielectric layers (110, 114) interposed between the first and third arrays of conducting lines (108, 116) and each electrically connecting one of the intersections (120) of the first array of conducting lines (108) to one of the intersections (124) of the third array of conducting lines (116) through a conducting portion (125) of the second array which is electrically insulated from the conducting lines (112) of the second array.

3. Electronic device (100) according to one of previous claims, further comprising at least one second conducting via (127) extending through at least one part of at least one of the dielectric layers (110, 114) interposed between the first and third arrays of conducting lines (108, 116), in contact with at least one of the conducting lines (112) of the second array and such that a section of the second conducting via (127) projected in a plane in which the conducting lines (108) of the first array pass is not in contact with the conducting lines (108) of the first array.

4. Electronic device (100) according to claim 3, comprising several second conducting vias (127) extending through the dielectric layers (110, 114) interposed between the first and third arrays of conducting lines (108, 116), each being in contact with one of the intersections (122) of the second array of conducting lines (112) and with a conducting portion (129) of the first array which is electrically insulated from the conducting lines (108) of the first array and/or a conducting portion (129) of the third array which is electrically insulated from the conducting lines (116) of the third array.

5. Electronic device (110) according to one of previous claims, in which the first and third patterns of the conducting lines (108, 116) of the first and third arrays correspond respectively to a first and a third grid layouts aligned and superimposed one on top of the other, and in which the second pattern of the conducting lines (112) of the second array corresponds to a second grid layout offset with respect to the first and third grid layouts.

6. Electronic device (100) according to claims 2, 4 and 5, in which the first conducting vias (126) traverse openings formed in the second grid layout and the second conducting vias traverse openings (134) formed in at least one of the first and third grid layouts.

7. Electronic device (100) according to one of previous claims, in which the conducting lines (108, 112, 116) of a same array intersect in a substantially perpendicular manner.

8. Electronic device (100) according to one of previous claims, in which at least one of the first of the conducting lines (108.1, 108.2, 108.3, 112.1, 112.2) of one of the arrays is interrupted.

9. Electronic device (100) according to one of previous claims, further comprising one or more other arrays of conducting lines superimposed on the first, second and third arrays of conducting lines (108, 112, 116) and of which the conducting lines form a similar pattern and aligned with the first or with the second pattern such that the patterns formed by the conducting lines (108, 112, 116) of the set of arrays correspond to an alternating superposition of the first and second patterns.

10. Electronic device (100) according to one of previous claims, further comprising at least one analogue integrated circuit (104) and in which the interconnection structure (102) forms ground and electrical supply planes of said at least one analogue integrated circuit (104).

11. Method for producing an electronic device (100) comprising an electrical interconnection structure (102) forming at least one electrical conduction path between at least two points of the electronic device (100) and/or at least one electrically conducting plane, in which the method comprises a step of computer aided design of the electrical conduction path and/or of the electrically conducting plane from several similar connection cells (130) each modelling a part of an alternating stack of arrays of conducting lines (108, 112, 116) and dielectric layers (106, 110, 114, 118) in which:
- all the conducting lines (108, 112, 116) of a same array extend in a same plane and form an equipotential;
- a first pattern of the conducting lines (108) of a first array is such that at least one first of the conducting lines (108.1, 108.2, 108.3) of the first array extends along at least one first direction and several second of the conducting lines (108.4, 108.5, 108.6) of the first array intersect the first of the conducting lines (108.1, 108.2, 108.3) of the first array at several intersections (120);
- a third pattern of the conducting lines (116) of a third array is similar to the first pattern, the first and third patterns being superimposed one on top of the other and such that the intersections (120) of the first pattern are aligned with the intersections (124) of the third pattern along an axis substantially perpendicular to the planes in which the conducting lines (108, 116) of the first and third arrays extend;
- a second pattern of the conducting lines (112) of a second array arranged between the first and third arrays of conducting lines (108, 116) is such that at least one first of the conducting lines (112.1, 112.2) of the second array extends along the first direction and several second of the conducting lines (112.3, 112.4) of the second array intersect the first of the conducting lines (112.1, 112.2) of the second array at several intersections (122) offset with respect to the intersections (120, 124) of the first and third patterns;
- at least one first conducting via (126) extends through at least one part of at least one of the dielectric layers (110, 114) interposed between the first and third arrays of conducting lines (108, 116), is in contact with at least one of the conducting lines (108, 116) of the first array and/or of the third array and such that a section of the first conducting via (126) projected in a plane in which the conducting lines (112) of the second array pass is not in contact with the conducting lines (112)of the second array;
and in which, during the step of computer aided design of the electrical conduction path and/or of the electrically conducting plane, a plurality of connection cells (130) are juxtaposed and placed in contact laterally with each other to form the electrical conduction path and/or the electrically conducting plane.

12. Method according to claim 11, in which the first and third patterns of the conducting lines (108, 116) of the first and third arrays correspond to a first and a third grid layouts aligned one on top of the other, and in which the second pattern of the conducting lines (112) of the second array corresponds to a second grid layout offset with respect to the first and third grid layouts.

13. Method according to one of claims 11 or 12, in which each of the connection cells (130) is such that at least one of the conducting lines (108, 112, 116) of each of the arrays extends between a first corner or a first edge of the connection cell (130) and a second corner or a second edge of the connection cell (130).

14. Method according to one of claims 11 to 13, in which each of the connection cells (130) comprises at least one part of the first of the conducting lines (108, 112, 116) and at least one of the second of the conducting lines (108, 112, 116) of each of the arrays.
